# EUROPEAN PATENT SPECIFICATION

(11) **EP 4 664 515 B1**
(45) Date of publication and mention of the grant of the patent: **05.08.2026**
(21) Application number: 25181684.9
(22) Date of filing: 10.06.2025
(51) Int. Cl.: H10W 40/47, H10W 70/09, H10W 70/60, H10W 90/00, H10W 70/63

(54) **PANEL-SCALE OR WAFER-SCALE SEMICONDUCTOR DEVICE**
HALBLEITERANORDNUNG IN PLATTEN- ODER SCHEIBENGRÖSSE
DISPOSITIF SEMI-CONDUCTEUR À L'ÉCHELLE D'UN PANNEAU OU D'UNE TRANCHE

(30) Priority: 12.06.2024 US 202463659134 P; 09.05.2025 US 202519203682
(43) Date of publication of application: 17.12.2025
(73) Proprietor: Samsung Electronics Co., Ltd., Suwon-si, Gyeonggi-do 16677 (KR)
(72) Inventor: LI, Yan, San Jose, CA, 95134, (US); KIM, WooPoung, San Jose, CA, 95134 (US)
(74) Representative: Kuhnen & Wacker Patent- und Rechtsanwaltsbüro PartG mbB

(56) References cited:
- US-A1- 2017 170 155
- US-A1- 2020 006 252
- US-A1- 2021 183 794
- US-A1- 2022 415 814
- US-A1- 2024 063 066
- US-A1- 2024 063 183

## Description

### BACKGROUND

### 1. Field

Embodiments of the present disclosure relate to a semiconductor device (e.g., package), a semiconductor system, and a method of manufacturing thereof, and, more particularly, a panel-scale or wafer-scale semiconductor device (e.g., package) and a method of manufacturing thereof.

### 2. Description of Related Art

US 2022/415814 A1 discloses certain microelectronic assemblies, related devices and methods. In some embodiments of this prior art document, a microelectronic assembly may include a package substrate including a first conductive pathway electrically coupled to a power source; a first microelectronic component embedded in an insulating material on the surface of the package substrate and including a TSV electrically coupled to the first conductive pathway; a redistribution layer (RDL) on the insulating material including a second conductive pathway electrically coupled to the TSV; and a second microelectronic component on the RDL and electrically coupled to the second conductive pathway, wherein the second conductive pathway electrically couples the TSV, the second microelectronic component, and the first microelectronic component.

US 2017/170155 A1 discloses a method and device, wherein a first semiconductor device and a via are encapsulated with an encapsulant. A redistribution layer connects the first semiconductor device to a second semiconductor device. In a particular embodiment the first semiconductor device is an integrated voltage regulator and the second semiconductor device is a logic device such as a central processing unit.

US 2020/006252 A1 discloses a method that includes placing a plurality of functional dies over a carrier, placing a plurality of dummy dies over the carrier, encapsulating the plurality of functional dies and the plurality of dummy dies in an encapsulant, and forming redistribution lines over and interconnecting the plurality of functional dies. The redistribution lines, the plurality of functional dies, the plurality of dummy dies, and the encapsulant in combination form a reconstructed wafer. The plurality of functional dies are in a center region of the reconstructed wafer, and the plurality of dummy dies are in a peripheral region of the reconstructed wafer, with the peripheral region encircling the center region. The reconstructed wafer is de-bonded from the carrier. The reconstructed wafer is bonded to a package component selected from the group consisting essentially of an interposer, a package substrate, a printed circuit board, a thermal module, and combinations thereof.

US 2024/063066 A1 discloses certain microelectronic assemblies, related devices and methods. In some embodiments of this prior art document, a microelectronic assembly may include a first die having a surface; a template structure having a first surface and an opposing second surface, wherein the first surface of the template structure is coupled to the surface of the first die, and wherein the template structure includes a cavity at the first surface and a through-template opening extending from a top surface of the cavity to the second surface of the template structure; and a second die within the cavity of the template structure and electrically coupled to the surface of the first die by interconnects having a pitch of less than 10 microns between adjacent interconnects.

US 2021/183794 A1 discloses a package structure including a first die; a plurality of through vias, aside the first die; a first encapsulant laterally encapsulating the first die and the plurality of through vias; a first redistribution layer, RDL, structure on first sides of the first die, plurality of through vias, and the first encapsulant; a second RDL structure on second sides of the first die, the plurality of through vias, and the first encapsulant; and a plurality of conductive connectors, electrically connected to the second RDL structure. Portions of the first RDL structure, the plurality of through vias, and the second RDL structure are electrically connected to each other and form a solenoid inductor laterally aside the first die.

US 2024/063183 A1 discloses a microelectronic assembly that comprises: a plurality of layers of monolithic wafers and disaggregated integrated circuit, IC, dies, adjacent layers being coupled together by first interconnects having a pitch less than 10 micrometers between adjacent first interconnects, the disaggregated IC dies arranged with portions of the monolithic wafers into modular sub-assemblies; and a package substrate coupled to the modular sub-assemblies by second interconnects having a pitch greater than 10 micrometers between adjacent second interconnects. The disaggregated IC dies are surrounded laterally by a dielectric material, and the disaggregated IC dies are arranged with portions of the monolithic wafers such that a voltage regulator circuit in a first layer of the plurality of layers, a compute circuit in a second layer of the plurality of layers, and a memory circuit in a third layer of the plurality of layers are conductively coupled together in an intra-modular power delivery circuitry.

Some artificial intelligence (AI) applications demand high performance computing (HPC), which may need a bigger package footprint, in comparison to applications demanding lower performance computing, for heterogeneous integration of more central processing units (CPUs), graphics processing units (GPUs), memories, and AI chips. A wafer-scale device, circuit, etc., or a system-on-wafer (SoW), has been developed for supercomputer applications. However, there is a need for ever faster AI training devices, circuits, etc. with better thermal management and power integrity drive development of large packages with better performance.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The invention is set out in the appended claims.

Embodiments of the present disclosure may address the above problems and/or other problems.

According to some example embodiments of the present disclosure, a semiconductor device (e.g., a semiconductor package or a semiconductor device, circuit, etc.) may be provided and include CPUs, GPUs, application-specific integrated circuits (ASICs), memories, and/or any other chips (or chiplets, field programmable gate array (FPGA), processor, coprocessor, etc.) embedded in a wafer-scale or panel-scale Si or glass substrate to form a wafer-scale or panel-scale semiconductor device (e.g., a wafer-scale or panel-scale AI training device, circuit, etc.).

According to some example embodiments of the present disclosure, the various chips embedded in the Si or glass substrate may be connected through redistribution layers (RDL) with dense traces. Signal and power connection of the wafer-scale or panel-scale device, circuit, etc. may be disposed along edges thereof or vertically on top of each chip. A voltage regulator module (VRM) may be attached on top of each chip to provide power.

According to some example embodiments of the present disclosure, to further enhance the power integrity (PI) performance, integrated stacked capacitor (ISC) Si interposers can be integrated between the VRMs and the individual chips. A liquid cooling cold plate may be attached to the backside of the Si or glass substrate for better thermal management. Additionally, liquid cooling channels may be created within the Si or glass substrate to help manage the thermal dissipation of the semiconductor device. Thermal vias may also be provided within the Si or glass substrate for better thermal management.

According to some example embodiments of the present disclosure, a semiconductor device may be provided and include: a substrate; and semiconductor assemblies that are configured to be electrically connected together, each of the semiconductor assemblies including: a first semiconductor chip that is at least partially between a first surface of the substrate and a second surface of the substrate, the first surface facing in a first direction and the second surface facing in a second direction, opposite to the first direction; and a voltage regulator that is on the first surface of the substrate, overlaps with the first semiconductor chip in the first direction, and is configured to be electrically connected to the first semiconductor chip.

According to some example embodiments of the present disclosure, a semiconductor device may be provided and include: a substrate; semiconductor assemblies each of which includes: a first semiconductor chip that is on a first surface of the substrate that faces in a first direction; and a voltage regulator that overlaps with the first semiconductor chip in the first direction, and is configured to be electrically connected to the first semiconductor chip; and a bridge die that is at least partially between the first surface of the substrate and a second surface of the substrate, opposite to the first surface, the bridge die configured to electrically connect the semiconductor assemblies.

According to some example embodiments of the present disclosure, a method of manufacturing a semiconductor device may be provided and include: providing first semiconductor chips in a substrate; and providing voltage regulators on a first surface of the substrate that faces in a first direction, such that each of the voltage regulators overlaps a respective one of the first semiconductor chips in the first direction and is configured to be electrically connected to the respective one of the first semiconductor chips.

### BRIEF DESCRIPTION OF DRAWINGS

Example embodiments of the present disclosure will be more clearly understood from the following detailed description taken in conjunction with the accompanying drawings in which:
FIG. 1 illustrates a schematic plan view showing a semiconductor device according to an example embodiment of the present disclosure;
FIG. 2 illustrates a schematic plan view showing a portion of the semiconductor device of FIG. 1, according to an example embodiment of the present disclosure;
FIG. 3A illustrates a schematic cross-sectional view showing a semiconductor device according to an example embodiment of the present disclosure;
FIG. 3B illustrates a schematic cross-sectional view showing a semiconductor device including at least one liquid cooling channel, according to an example embodiment of the present disclosure;
FIG. 3C illustrates a schematic cross-sectional view showing a semiconductor device including thermal vias, according to an example embodiment of the present disclosure;
FIG. 4A illustrates a schematic cross-sectional view showing a semiconductor device including an interposer, according to an example embodiment of the present disclosure;
FIG. 4B illustrates a schematic cross-sectional view showing a semiconductor device including an interposer and liquid cooling channels, according to an example embodiment of the present disclosure;
FIG. 4C illustrates a schematic cross-sectional view showing a semiconductor device including an interposer and thermal vias, according to an example embodiment of the present disclosure;
FIG. 5 illustrates a flowchart for a method of manufacturing a semiconductor device according to an example embodiment of the present disclosure;
FIGS. 6A-J illustrate intermediate semiconductor devices formed in operations of the method of FIG. 5, according to example embodiments of the present disclosure;
FIG. 6K illustrates the semiconductor device manufactured in an operation of the method of FIG. 5, according to an example embodiment of the present disclosure;
FIG. 7 illustrates a flowchart for a method of manufacturing a semiconductor device according to an example embodiment of the present disclosure;
FIGS. 8A-E illustrate intermediate semiconductor devices formed in operations of the method of FIG. 7, according to example embodiments of the present disclosure;
FIG. 8F illustrates the semiconductor device manufactured in an operation of the method of FIG. 7, according to an example embodiment of the present disclosure;
FIG. 9 illustrates a flowchart for a method of manufacturing voltage regulation assemblies according to an example embodiment of the present disclosure;
FIG. 10A illustrates an intermediate semiconductor device formed in operations of the method of FIG. 9, according to an example embodiment of the present disclosure;
FIG. 10B illustrates an intermediate semiconductor device formed in operations of the method of FIG. 9, according to an example embodiment of the present disclosure;
FIG. 10C illustrates the voltage regulation assemblies manufactured in an operation of the method of FIG. 9, according to an example embodiment of the present disclosure;
FIG. 11 illustrates a flowchart for a method of manufacturing a semiconductor device according to an example embodiment of the present disclosure;
FIG. 12A illustrates a schematic cross-sectional view showing a semiconductor device including a second semiconductor chip between a first semiconductor chip and an interposer, according to an example embodiment of the present disclosure;
FIG. 12B illustrates a schematic cross-sectional view showing a semiconductor device including two second semiconductor chips, according to an example embodiment of the present disclosure;
FIG. 12C illustrates a schematic cross-sectional view showing a semiconductor device including three second semiconductor chips, according to an example embodiment of the present disclosure;
FIG. 13A illustrates a schematic cross-sectional view showing a semiconductor device including bridge dies and a second semiconductor chip, according to an example embodiment of the present disclosure;
FIG. 13B illustrates a schematic cross-sectional view showing a semiconductor device including bridge dies and two second semiconductor chips, according to an example embodiment of the present disclosure; and
FIG. 13C illustrates a schematic cross-sectional view showing a semiconductor device including bridge dies and three second semiconductor chips, according to an example embodiment of the present disclosure.

### DETAILED DESCRIPTION

Embodiments of the present disclosure described herein are example embodiments, and thus, the present disclosure is not limited thereto, and may be realized in various other forms. Each of the embodiments provided in the following description is not excluded from being associated with one or more features of another embodiment also provided herein or not provided herein but consistent with the present disclosure. For example, even if matters described in a specific example embodiment are not described in a different example embodiment, the matters may be understood as being related to or combined with the different example embodiment, unless otherwise mentioned in descriptions thereof.

It will be understood that when an element, component, layer, pattern, structure, region, or so on (hereinafter collectively "element") of a semiconductor device (or semiconductor package) is referred to as being "on," "connected to," or "coupled to" another element the semiconductor device, it can be directly on, connected to, or coupled to the other element or an intervening element(s) may be present. In contrast, when an element of a semiconductor device is referred to as being "directly on," "directly connected to," or "directly coupled to" another element of the semiconductor device, there are no intervening elements present. Like numerals refer to like elements throughout the present disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions here below, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element to distinguish the two elements.

It will be understood that, although the terms "first," "second," "third," "fourth," "fifth," "sixth," etc., may be used herein to describe various elements, these elements should not be limited by these terms. These terms are only used to distinguish one element from another element. Thus, a first element discussed below could be termed a second element without departing from the scope of the present disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, when a method of manufacturing an apparatus or structure is described as including a plurality of steps or operations, a certain step or operation described as being performed later than another step or operation may be performed prior to or at the same time as the other step or operation unless the other step or operation is described as necessarily being performed prior to the step or operation. Further, the method may include additional steps or operations not mentioned in the description.

Many example embodiments are described herein with reference to cross-sectional views that are schematic illustrations of the embodiments (and intermediate structures). As such, variations from the shapes of the illustrations as a result of, for example, manufacturing techniques and/or tolerances are to be expected. Thus, the embodiments should not be construed as limited to the particular shapes of regions illustrated herein, and are to include deviations in shapes that result from, for example, manufacturing. Various regions illustrated in the figures are schematic in nature and their shapes may not be intended to illustrate the actual shape of a region of a device and are not intended to limit the scope of the present disclosure. Further, in the drawings, the sizes and relative sizes of layers and regions may be exaggerated for clarity.

For the sake of brevity, conventional elements, structures, or layers included in a semiconductor package including a connection pad, an adhesive layer, an isolation layer, a barrier metal pattern, a seed layer, etc. may or may not be described in detail herein. For example, descriptions of certain connection pads of a semiconductor chip connected to solder balls or bumps in a semiconductor package may be omitted herein when these structural elements are not related to certain features of the embodiments. Also, descriptions of materials forming well-known structural elements may be omitted herein when those materials are not relevant to certain features of the embodiments. Herein, the term "connection" between two structures or elements may refer to an electrical connection therebetween. For example, a connection between semiconductor chips, semiconductor packages, and/or semiconductor devices may refer to an electrical connection of a corresponding two or more elements to each other. The terms "coupled" and "connected" may have the same meaning and may be used interchangeably herein. Further, the term "isolation" between two structures or elements pertains to electrical insulation or separation therebetween. For example, isolation of wiring patterns from each other may mean that the wiring patterns are not electrically connected to each other.

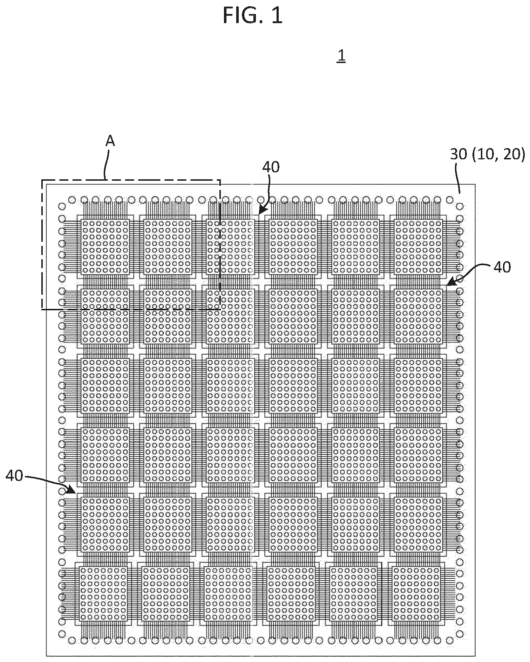

Hereinafter, various example embodiments of the present disclosure are described with reference to FIGS. 1-13C.

According to comparative embodiments, wafer-scale devices, circuits, etc., may be produced by a single wafer with silicon (Si) lithography and used in AI training. However, in the comparative embodiments, it may be difficult to yield an entire wafer, especially for advanced silicon (Si) nodes with diameters approximately 2 nm and beyond.

According to comparative embodiments, integrated fan-out (InFO) system-on-wafer (SoW) wafer-level packaging techniques may be used to manufacture an HPC. For example, a molding compound, a copper (Cu) pillar, and a redistribution layer (RDL) may be utilized to connect individual chips together. However, according to the comparative embodiments, a manufacturing process of a super computer using the InFo SoW techniques included mechanical grinding of the molding compound, which could lead to yield loss and reliability concerns. Additionally, in the comparative embodiments, there are issues with warpage control, thermal mechanical stress, thermal management, and power integrity of InFO SoW that needs to be addressed.

Some packages that include organic, Si, or glass substrates are relatively small, and do not reach wafer-scale (e.g., approximately 300 mm in diameter) or panel-scale (e.g., greater than or equal to approximately 400 by 500 mm).

Embodiments of the present disclosure may address the above problems and/or other problems.

For example, a semiconductor device (e.g., a semiconductor package or a semiconductor device, circuit, etc.) according to some example embodiments of the present disclosure may include CPUs, GPUs, application-specific integrated circuits (ASICs), memories, and/or any other chips (or chiplets) embedded in a wafer-scale or panel-scale Si or glass substrate to form a wafer-scale or panel-scale semiconductor device (e.g., a wafer-scale or panel-scale AI training device, circuit, etc.). The various chips embedded in the Si or glass substrate may be connected through redistribution layers (RDL) with dense copper (Cu) traces. Signal and power connection of the wafer-scale or panel-scale device, circuit, etc., may be disposed along edges thereof or vertically on top of each chip. A voltage regulator module (VRM) may be attached on top of each chip to provide power. To further enhance the power integrity (PI) performance for a high power device designed for high performance computing (HPC) and AI training, integrated stacked capacitor (ISC) Si interposers can be integrated between the VRMs and the individual chips. A liquid cooling cold plate may be attached to the backside of the Si or glass substrate for better thermal management. Additionally, liquid cooling channels may be created within the Si or glass substrate to help manage the thermal dissipation of the semiconductor device. Thermal vias may also be provided within the Si or glass substrate for better thermal management.

The semiconductor device (e.g., a panel-scale or wafer-scale AI training device, circuit, etc.) according to some embodiments may be manufactured using advanced wafer-level or panel-level packaging techniques, and may include an Si or glass substrate. An ISC technique may be applied to one or more example embodiments of the present disclosure to provide better PI performance. Advanced thermal management solutions, such as liquid cooling and thermal vias may also be included in the semiconductor device for better thermal performance.

According to some embodiments, a manufacturing process of the semiconductor device (e.g., a semiconductor device, circuit, etc.) may be provided. For example, the manufacturing process may include embedding CPUs, GPUs, ASICs, and/or memory chips into an Si or glass substrate, attaching VRMs, integrating an integrated stack capacitor (ISC) Si interposer, and creating liquid cooling channels and thermal vias within the Si or glass substrate.

According to some embodiments, wafer-scale or panel-scale glass and Si package architectures integrating ISCs, liquid cooling, and thermal vias for different applications involving, for example, CPUs, GPUs, AI chips, SOCs, system-in-packages (SIPs), etc., may be provided.

According to some embodiments, a wafer-scale or panel-scale system architecture (e.g., a semiconductor device such as a semiconductor device, circuit, etc.) may be provided that includes a wafer-scale or panel-scale substrate, formed of Si or glass, and provides a better mechanical support to the large system. Discrete semiconductor chips including, for example, CPUs, GPUs, ASICs, and memory chips, may be embedded in the substrate. One or more RDLs may then be applied to connect all of the discrete semiconductor chips together. Signal and power connection of the semiconductor chips may be either at the edges of the wafer-scale or panel-scale system architecture, or on top of each semiconductor chip. Individual VRMs may be attached on top of each semiconductor chip to provide power vertically.

According to some embodiments, to further improve the PI performance, an individual ISC Si interposer may be integrated between each VRM and an embedded chip to provide better power delivery network (PDN) performance to each ASIC or memory chip.

According to some embodiments, a liquid cooling plate, having the same size of the wafer-scale or panel-scale device, circuit, etc., may be attached to the back side of the Si or glass substrate for better thermal management of the entire system. Additionally, liquid cooling channels and thermal vias may be formed inside the Si or glass substrate to help further enhance the thermal dissipation of the wafer-scale or panel-scale system (e.g., the semiconductor device).

Comparing with a wafer-scale device, circuit, etc., made from a single wafer, semiconductor devices (e.g., semiconductor devices, circuits, etc.) according to some embodiments have an advantage of a higher yield. Instead of yielding an entire wafer, "test-good" small dies can be picked and integrated into the system (e.g., the semiconductor device or the semiconductor device). Thus, in comparison to comparative embodiments, some example embodiments of the present disclosure may achieve significantly increased efficiency in manufacturing a wafer-scale device, circuit, etc. Additionally, semiconductor devices (e.g., semiconductor devices, circuits, etc.) according to some embodiments can be built to have a panel-scale, which may be equal to or larger than approximately 400 mm by 500 mm in size in some example embodiments. Thermal management may also be improved in semiconductor devices (e.g., semiconductor devices, circuits, etc.) according to some embodiments, as liquid cooling channels and thermal vias may be utilized to further enhance the thermal performance. Semiconductor devices (e.g., semiconductor devices, circuits, etc.) according to some embodiments may also improve power distribution (or delivery) network (PDN) performance because ISCs may be integrated very close to ASIC or memory chips. For example, the ISC may be embedded in an interposer (e.g., interposer 43) underneath the VRM, which may be right above the ASIC or memory chip. Depending on how many RDL layers are between the ASIC or memory chip and the interposer, the distance between the ISC and the ASIC or memory chip may range from, for example, about 20 um (e.g., one RDL layer may be provided) to about 60 um to 100 um (e.g., a few RDL layers may be provided, each RDL layer being about 15 um to 20 um thick). According to embodiments of the present disclosure, the distance may be more than 100 times shorter in comparison with the distance (e.g., a few mm) between a capacitor and a chip in a background embodiment.

Comparing with the integrated fan-out (InFO) system-on-wafer (SoW) techniques, which may be used to manufacture a super computer, semiconductor devices (e.g., semiconductor devices, circuits, etc.) according to some example embodiments of the present disclosure may have, for example, the following advantages: (1) the semiconductor devices (e.g., semiconductor devices, circuits, etc.) may be expanded from a wafer-scale of approximately 300 mm in diameter to a panel-scale of equal to or greater than approximately 400 mm by 500 mm in size, thus allowing for more chip integration and better performance; (2) the semiconductor devices (e.g., semiconductor devices, circuits, etc.) may not include a molding compound material and a mechanical grinding process, thereby providing better thermal performance and less mechanical stress concerns; (3) the semiconductor devices (e.g., semiconductor devices, circuits, etc.) may have better thermal management performance due to the adoption of liquid cooling channels and/or thermal vias in an Si or glass substrate; and (4) the semiconductor devices (e.g., semiconductor devices) may have better PDN performance because of the integration of ISCs close to ASIC or memory chips.

With reference to FIGS. 1-4C, semiconductor devices (e.g., semiconductor devices, circuits, etc.) according to some example embodiments of the present disclosure are described below.

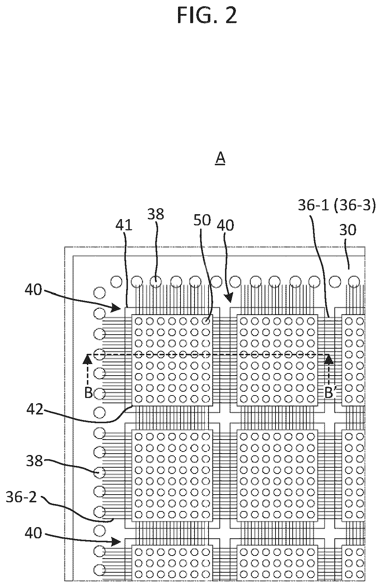

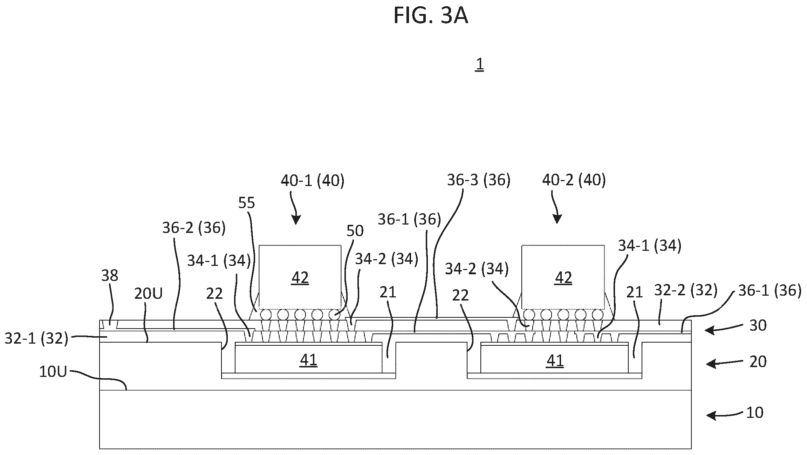

FIG. 1 illustrates a schematic plan view showing a semiconductor device according to an example embodiment of the present disclosure. FIG. 2 illustrates a schematic plan view showing a portion A of the semiconductor device of FIG. 1, according to an example embodiment of the present disclosure. FIGS. 3A-4C illustrate schematic cross-sectional views of semiconductor devices according to some example embodiments of the present disclosure, taken along a line B-B' of FIG. 2.

With reference to FIGS. 1-3A, a semiconductor device 1 may be provided. The semiconductor device 1 may be a semiconductor package. More specifically, the semiconductor device 1 may be a wafer-scale or panel-scale semiconductor device, circuit, etc. The semiconductor device 1 may include, for example, a liquid cooling cold plate 10, a substrate 20, at least one redistribution layer (RDL) 30, and semiconductor assemblies 40.

With reference to FIG. 3A, the liquid cooling cold plate 10 may be a bottom portion of the semiconductor device 1, and may be configured to provide cooling to components provided thereon. For example, the liquid cooling cold plate 10 may have a high thermal conductivity. For example, the liquid cooling cold plate 10 may be a plate made of a metal (e.g., copper). The liquid cooling cold plate 10 may also include channels in which a liquid moves so as to further provide heat transfer (e.g., cooling) to components provided on the liquid cooling cold plate 10. For example, heat of the components may be transferred to the liquid within the channels of the liquid cooling cold plate 10, such that the components are cooled. The liquid cooling cold plate 10 may have a rectangular shape (e.g., a square shape) or a circular shape in a plan view (see FIG. 1), but embodiments of the present disclosure are not limited thereto. Additionally, a shape and/or size of the liquid cooling cold plate 10 in a plan view (see FIG. 1) may be the same as a shape and/or size of the substrate 20 to be described below. In a plan view (see FIG. 1), the shape and size of the liquid cooling cold plate 10 may correspond to (e.g., be the same as) an overall shape and size of the semiconductor device 1, but embodiments of the present disclosure are not limited thereto.

The substrate 20 may be provided on a top surface 10U of the liquid cooling cold plate 10. For example, the substrate 20 may be provided directly on the top surface 10U of the liquid cooling cold plate 10, such as to be in direct contact with the top surface 10U of the liquid cooling cold plate 10. The substrate 20 may be, for example, a glass substrate or a silicon (Si) substrate, and may be, for example, a wafer-level or a panel-level substrate. That is, the substrate 20 may be made of, for example, glass or silicon (Si). For example, the substrate 20 may mainly include glass or silicon, or may consist of only glass or silicon. However, a material of the substrate 20 is not limited to glass or silicon. For example, the substrate 20 may include germanium (Ge), gallium arsenide (GaA), sapphire, aluminum oxide (Al2O3), silicon carbide (SiC), indium phosphide (InP), silicon germanium (SiGe), zinc oxide (ZnO), etc. Additionally, the substrate 20 may be or include a hybrid substrate including two or more materials (e.g., metal, ceramic, and/or organic materials), including the aforementioned materials.

In a case where the substrate 20 is a wafer-level substrate, the substrate 20 may have the circular shape and may have a diameter in a plan view (see FIG. 1) of, for example, at least 210 mm. For example, the diameter may be 300 mm. In a case where the substrate 20 is a panel-level substrate, the substrate 20 may have the rectangular shape and may have a smallest dimension in a plan view (see FIG. 1) of, for example, 400 mm. For example, in the plan view (see FIG. 1), the substrate 20 may have a size of 400 mm by 510 mm, 510 mm by 510 mm, 600 mm by 600 mm, etc. However, the size of substrate 20 is not limited the aforementioned sizes, and may include various sizes. According to some example embodiments, the substrate 20 may be formed from a panel-level substrate by, for example, cutting the panel-level substrate. Thus, the substrate 20 may have a reduced size in comparison to the original panel-level substrate. For example, the substrate 20 may have the rectangular size and may have a smallest dimension in a plan view (see FIG. 1) of, for example, 200 mm.

The substrate 20 may have a rectangular shape (e.g., a square shape) or a circular shape in a plan view (see FIG. 1), but embodiments of the present disclosure are not limited thereto. In a plan view (see FIG. 1), the shape and size of the substrate 20 in a plan view (see FIG. 1) may correspond to (e.g., be the same as) an overall shape and size of the semiconductor device 1, but embodiments of the present disclosure are not limited thereto.

With reference to FIG. 3A, the substrate 20 may include a plurality of recesses 22 (also referred to as cavities) that respectively correspond to the semiconductor assemblies 40 to be described below. For example, the recesses 22 may be recessed in a top surface 20U of the substrate 20, and may each include a portion of a respective one of the semiconductor assemblies 40 therein. For example, in a case where 56 semiconductor assemblies 40 are provided in the semiconductor device 1 in an array format (e.g., an 8 by 7 array format), there may be 56 recesses 22 in the substrate 20 in the same array format, but embodiments of the present disclosure are not limited thereto.

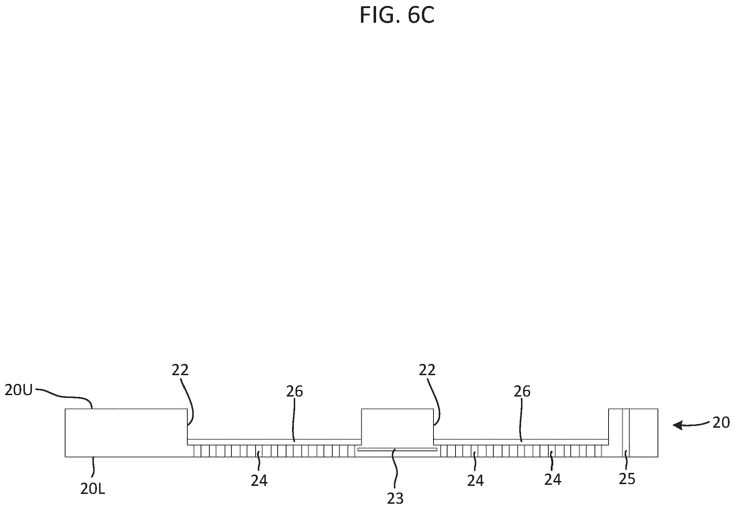

According to some example embodiments of the present disclosure, a die backside film 26 (see FIG. 6C) may be provided on a bottom surface of each of the recesses 22. For example, the die backside film 26 may adhere the semiconductor chips 41 in the recesses 22 and/or protect the backside of the semiconductor chips 41. For example, each of the die backside films 26 may be in direct contact with the bottom surface of a respective one of the recesses 22, and backsides of semiconductors chips 41 may be in direct contact with the top surfaces of the die backside films 26, respectively. The die backside films 26 may be, for example, organic polymer films.

Also, in each of the recesses 22, a dielectric material 21 may be provided so as to surround the portion of the semiconductor assemblies 40 within the recess 22 in at least horizontal directions. For example, the dielectric material 21 may be provided on the top surface of the die backside films 26. The dielectric material 21 may be made of, for example, an epoxy resin, polyimide, etc., but embodiments of the present disclosure are not limited thereto.

With reference to FIGS. 1-3A, the at least one RDL 30 may be provided on the top surface 20U of the substrate 20. For example, the at least one RDL 30 may be provided directly on the top surface 20U of the substrate 20, such as to be in direct contact with the top surface 20U of the substrate 20. The at least one RDL 30 may be configured to provide die-to-die connection. For example, the at least one RDL 30 may be configured to electrically connect together first semiconductor chips 41 (also referred to as semiconductor dies) from among different ones of the semiconductor assemblies 40. Additionally, the at least one RDL 30 may be configured to electrically connect together components (e.g., the first semiconductor chip 41 and a voltage regulator 42) of a same semiconductor assembly 40, and/or electrically connect the semiconductor assemblies 40 together and/or to a component outside of the semiconductor device 1.

The at least one RDL 30 may include at least one dielectric layer 32 and electrically conductive elements within the at least one dielectric layer 32. For example, the electrically conductive elements may include vias 34, traces 36 (e.g., lines), and pads 38.

The at least one dielectric layer 32 may be made of a dielectric material such as, for example, an epoxy resin, polyimide, etc., but embodiments of the present disclosure are not limited thereto. The at least one dielectric layer 32 may be, for example, build-up films or RDL dry films. As shown in FIG. 3A, two dielectric layers 32 may be provided, but embodiments of the present disclosure are not limited thereto. For example, one or three or more dielectric layers 32 may be provided. Among the dielectric layers 32, a lowermost dielectric layer 32-1 may be provided directly on the top surface 20U of the substrate 20, such as to be in direct contact with the top surface 20U of the substrate 20. Additionally, the lowermost dielectric layer 32-1 may be provided on top surfaces of the components (e.g., the first semiconductor chips 41) of the semiconductor assemblies 40 that are within the recesses 22 of the substrate 20, such as to be in direct contact with the top surfaces of the components.

According to some example embodiments of the present disclosure, the lowermost dielectric layer 32-1 may be integrally formed with the dielectric material 21 within the recesses 22 of the substrate 20. For example, the lowermost dielectric layer 32-1 and the dielectric material 21 may be formed of a same material as each other, and may be formed through a same process.

Each of the at least one dielectric layers 32 may have a rectangular shape (e.g., a square shape) or a circular shape in a plan view (see FIG. 1), but embodiments of the present disclosure are not limited thereto. In a plan view (see FIG. 1), the shape and size of the dielectric layers 32 may correspond to (e.g., be the same as) the shape and size of the semiconductor device 1, but embodiments of the present disclosure are not limited thereto. For example, each of the liquid cooling cold plate 10, the substrate 20, and the at least one dielectric layers 32 may have a same shape and size as each other in a plan view (see FIG. 1) such that outer side surfaces thereof are coplanar, but embodiments of the present disclosure are not limited thereto.

The vias 34 may penetrate through the at least one dielectric layers 32 to electrically connect together components above and below the at least one dielectric layers 32. For example, respective sets of vias 34 may be provided to penetrate through the dielectric layers 32, respectively. For example, as shown in FIG. 3A, first vias 34-1 among the vias 34 may penetrate through the lowermost dielectric layer 32-1, and second vias 34-2 among the vias 34 may penetrate through an uppermost dielectric layer 32-2.

According to some example embodiments of the present disclosure, bottom ends of the first vias 34-1 may be in direct contact with the upper surfaces of the components (e.g., the first semiconductor chip 41) of the semiconductor assemblies 40 that are within the recesses 22, and top ends of the first vias 34-1 may be in direct contact with the second vias 34-2, and/or one or more of the traces 36 that are directly on the top surface of the lowermost dielectric layer 32-1. Thus, the components (e.g., the first semiconductor chips 41) of the semiconductor assemblies 40 that are within the recesses 22 may be electrically connected to at least one of the traces 36 and/or at least one of the second vias 34-2 by at least one of the first vias 34-1.

For example, as shown in FIG. 3A, at least one (e.g., one) first via 34-1 that is on the first semiconductor chip 41 of one semiconductor assembly 40 (e.g., the semiconductor assembly 40-1) and is closest to another semiconductor assembly 40 (e.g., the semiconductor assembly 40-2) in a horizontal direction may be electrically connected, by a first trace 36-1 among the traces 36, to at least one (e.g., three) first via 34-1 that is on the first semiconductor chip 41 of the other semiconductor assembly 40 (e.g., the semiconductor assembly 40-2). Thus, adjacent ones of the semiconductor assemblies 40 (e.g., adjacent ones of the first semiconductor chips 41) may be electrically connected together by at least one first trace 36-1 and at least two first vias 34-1.

Also, according to some example embodiments of the present disclosure, top surfaces of at least one (e.g., one) of the first vias 34-1 on the first semiconductor chip 41 of the outermost ones of the semiconductor assemblies 40 (e.g., the semiconductor assembly 40-1 in FIG. 3A), that are closest to side edges of the semiconductor device 1 among the semiconductor assemblies 40, may be in direct contact with a second trace 36-2 among the traces 36. The second trace 36-2 may extend in at least one horizontal direction on the top surface of the lowermost dielectric layer 32-1 towards a side edge of the semiconductor device 1 such as to be electrically connected to at least one of the pads 38, which may be provided adjacent to the side edges of the semiconductor device 1. For example, the pads 38 may be extend through the uppermost dielectric layer 32-2, lower surfaces of the pads 38 may be in direct contact with an upper surface of one or more second traces 36-2, and upper surfaces of the pads 38 may be configured to electrically connect to other components (e.g., components external to the semiconductor device 1). Thus, for example, the semiconductor assemblies 40 may be electrically connected to the other components (e.g., components external to the semiconductor device 1) by at least one pad 38, at least one second trace 36-2, and at least one first via 34-1. According to some example embodiments of the present disclosure, the pads 38 may be configured to provide signal or power connections and may be input/output (I/O) pads.

According to some example embodiments of the present disclosure, bottom ends of the second vias 34-2 may be in direct contact with the upper surfaces of at least some of the first vias 34-1, and top ends of the second vias 34-2 may be in direct contact with solder joints 50, that are on the top surface of the uppermost dielectric layer 32-2, and/or one or more of the traces 36 that are directly on the top surface of the uppermost dielectric layer 32-2. Thus, the first semiconductor chip 41 of the semiconductor assemblies 40 that are within the recesses 22 may be electrically connected to at least one of the solder joints 50, and/or at least one of the traces 36 that are directly on the top surface of the uppermost dielectric layer 32-2, by at least one of the second vias 34-2. Also, other components (e.g., the voltage regulators 42) of the semiconductor assemblies 40, that are above the recesses 22 and the at least one RDL 30, may be electrically connected to the first semiconductor chip 41 of the semiconductor assemblies 40 within the recesses 22 therebelow, by at least one of the first vias 34-1, at least one of the second vias 34-2, and at least one of the solder joints 50.

According to some example embodiments of the present disclosure, the solder joints 50 may be bumps (e.g., micro bumps), but embodiments of the present disclosure are not limited thereto.

As shown in FIG. 3A, at least one (e.g., one) second via 34-2 that is on the first semiconductor chip 41 of one semiconductor assembly 40 (e.g., the semiconductor assembly 40-1) and is closest to another semiconductor assembly 40 (e.g., the semiconductor assembly 40-2) in a horizontal direction may be electrically connected by a third trace 36-3 among the traces 36 to at least one (e.g., one) second via 34-2 that is on the first semiconductor chip 41 of the other semiconductor assembly 40 (e.g., the semiconductor assembly 40-2). Thus, adjacent ones of the semiconductor assemblies 40 may be electrically connected together by at least one second trace 36-2 and at least two second vias 34-2.

According to some example embodiments of the present disclosure, each of the vias 34 (e.g., the first vias 34-1 and the second vias 34-2), the traces 36 (e.g., the first traces 36-1, the second traces 36-2, and the third traces 36-3), the pads 38, and the solder joints 50 may be made of an electrically conductive material such as, for example, a metal (e.g., copper).

Each of the semiconductor assemblies 40 may include, for example, a first semiconductor chip 41 and a voltage regulator 42. The first semiconductor chip 41 may be the component of the semiconductor assembly 40 embedded in the substrate 20, within the recess 22 of the substrate 20, and the voltage regulator 42 may be another component of the semiconductor assembly 40 that is on the top surface of the at least one RDL 30 and electrically connected to the first semiconductor chip 41 of the same semiconductor assembly 40 by the at least one RDL 30 (e.g., by at least one of the first vias 34-1 and at least one of the second vias 34-2) and at least one of the solder joints 50.

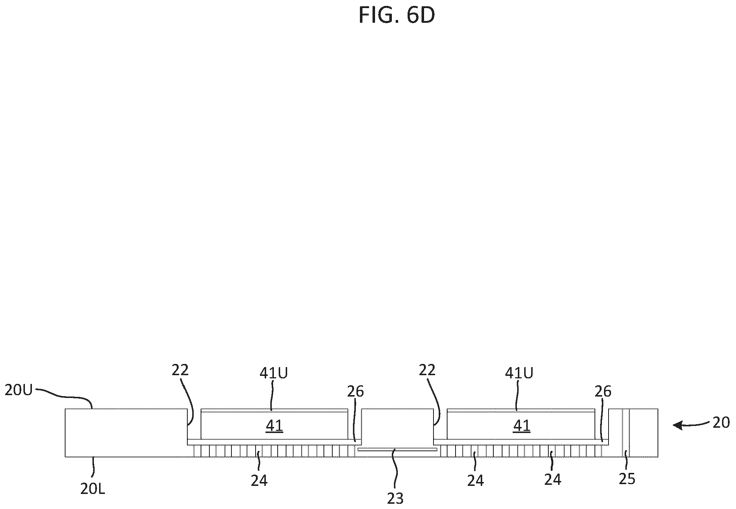

According to some example embodiments of the present disclosure, the first semiconductor chip 41 may be any type of semiconductor chip. For example, the first semiconductor chip 41 may be an application-specific integrated circuit (ASIC) chip or a memory chip, FPGA, processor, coprocessor, etc. The first semiconductor chip 41 may include a die front-side layer 41U (see FIG. 6D) at a top end of the first semiconductor chip 41, and the die front-side layer 41U may be electrically connected to the first vias 34-1 thereabove. According to some example embodiments of the present disclosure, the die front-side layer 41U may include metal interconnects (e.g., vias, traces, etc.) for connecting the first semiconductor chips 41 to other components (e.g., the first vias 34-1), and at least one dielectric layer. The metal interconnects may be made of, for example, copper.

According to some example embodiments of the present disclosure, the voltage regulator 42 may be configured to regulate a voltage applied to the first semiconductor chip 41 of the same semiconductor assembly 40. In each of the semiconductor assemblies 40, the voltage regulator 42 may overlap the first semiconductor chip 41 of the same semiconductor assembly 40. The voltage regulator 42 may also overlap at least one of the first vias 34-1, at least one of the second vias 34-2, and at least one of the solder joints 50 that electrically connect together the first semiconductor chip 41 and the voltage regulator 42 of the same semiconductor assembly 40. According to some example embodiments, the voltage regulator 42 may be a voltage regulator module (VRM).

According to some example embodiments of the present disclosure, the solder joints 50 may be surrounded, in at least horizontal directions, by an underfill 55 that is on the upper surface of the at least one RDL 30. For example, underfills 55 may be provided to respectively correspond to each of the semiconductor assemblies 40, such that a respective underfill 55 surrounds the solder joints 50 that are electrically connected to the voltage regulator 42 of each of the semiconductor assemblies 40. The underfills 55 may be configured to protect the solder joints 50 from mechanical and reliability failures.

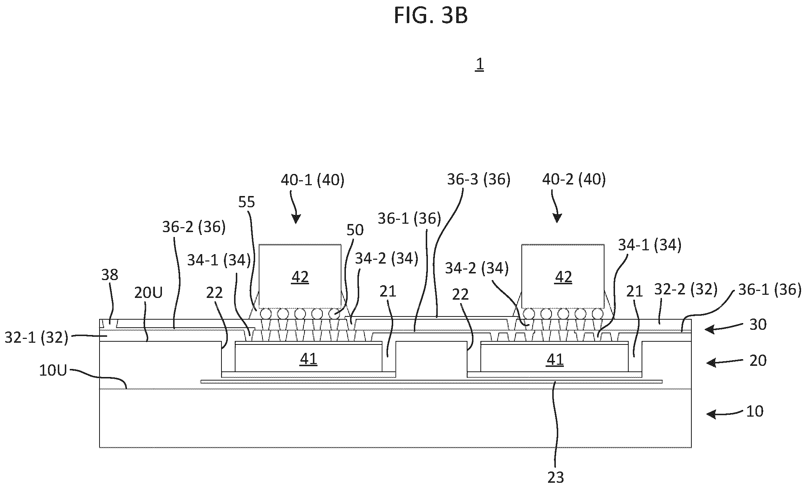

With reference to FIG. 3B, according to the invention of the present disclosure, the substrate 20 of the semiconductor device 1 includes at least one liquid cooling channel 23. The at least one liquid cooling channel 23 may be configured to improve thermal management performance of the semiconductor device 1 by, for example, transferring heat away from the semiconductor assemblies 40 (e.g., the first semiconductor chips 41). For example, the least one liquid cooling channel 23 may be configured to have a liquid (e.g., water) flow therein to receive heat, thereby cooling the semiconductor assemblies 40 (e.g., the first semiconductor chips 41). For example, the liquid cooling channel 23 may be provided underneath at least one of the first semiconductor chips 41 that are within the recesses 22. For example, the liquid cooling channel 23 may extend in at least one horizontal direction underneath at least one of the first semiconductor chips 41. For example, one liquid cooling channel 23 may extend underneath at least two of the first semiconductor chips 41 of at least two semiconductor assemblies 40, but embodiments of the present disclosure are not limited thereto.

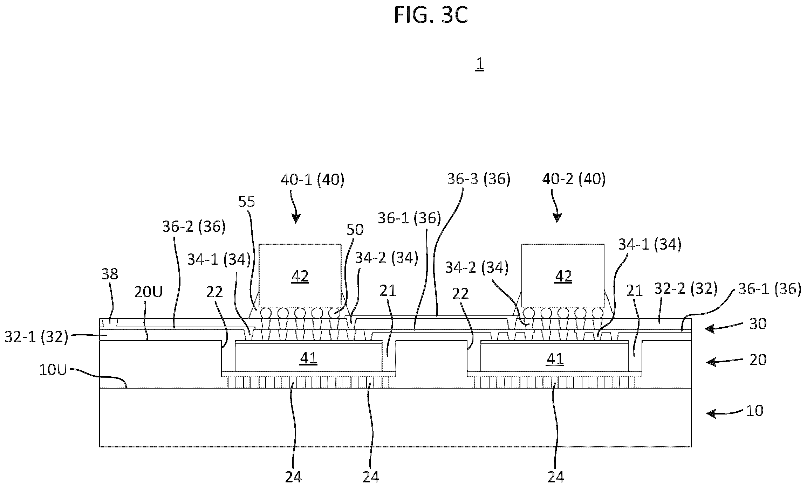

With reference to FIG. 3C, the substrate 20 of the semiconductor device 1 may alternatively or additionally include thermal vias 24. The thermal vias 24 may be configured to improve thermal management performance of the semiconductor device 1 by, for example, transferring heat away from the semiconductor assemblies 40 (e.g., the first semiconductor chips 41). For example, the thermal vias 24 may extend vertically through at least a portion of the substrate 20 transfer heat from the semiconductor assemblies 40 (e.g., the first semiconductor chips 41) to the liquid cooling cold plate 10. For example, top surfaces of the thermal vias 24 may be coplanar with bottom surfaces of the recesses 22, and bottom surfaces of the thermal vias 24 may be coplanar and in direct contact with the liquid cooling cold plate 10. According to some example embodiments of the present disclosure, a set of the thermal vias 24 may be respectively provided underneath one or more (e.g., all) of the recesses 22.

According to some example embodiments of the present disclosure, the semiconductor device 1 may include one or both from among the liquid cooling channels 23 (see FIG. 3B) and the thermal vias 24 (see FIG. 3C).

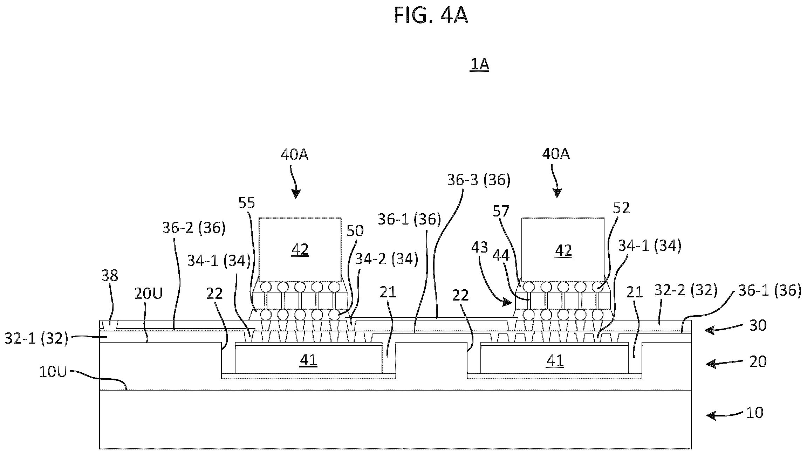

With reference to FIGS. 4A-C, a semiconductor device 1A may be provided. FIGS. 4A-C illustrate schematic cross-sectional views of the semiconductor device 1A according to example embodiments of the present disclosure. The semiconductor device 1A may be the same as or similar to the semiconductor device 1 described above with reference to FIGS. 1-3C, except that there may be differences with respect to semiconductor assemblies. Thus, repeated descriptions of the semiconductor device 1A may be omitted.

With reference to FIG. 4A, the semiconductor assemblies 40A may each further include an interposer 43 between the first semiconductor chip 41 and the voltage regulator 42. The interposer 43 may further improve PDN efficiency by, for example, facilitating shorter signal paths and/or enabling high-density interconnects. For example, the interposer 43 may be provided on the top surface of the at least one RDL 30 such as to be connected to the first semiconductor chip 41 by at least one of the first vias 34-1, at least one of the second vias 34-2, and the solder joints 50. Solder joints 52 may be provided between the interposer 43 and the voltage regulator 42, on a top surface of the interposer 43. For example, the solder joints 52 may electrically connect the voltage regulator 42 to the interposer 43. Thus, the voltage regulator 42 may be electrically connected to the first semiconductor chip 41 of the same semiconductor assembly 40A by the solder joints 52, the interposer 43 (e.g., electrical connection elements 44), the solder joints 50, at least one of the second vias 34-2, and at least one of the first vias 34-1.

According to some example embodiments of the present disclosure, the solder joints 52 may be surrounded, in at least horizontal directions, by an underfill 57 that is on the upper surface of the interposer 43. For example, underfills 57 may be provided to respectively correspond to each of the semiconductor assemblies 40A, such that a respective underfill 57 surrounds the solder joints 52 that are electrically connected to the voltage regulator 42 of each of the semiconductor assemblies 40A. The underfills 57 may be configured to protect the solder joints 52 from mechanical and reliability failures.

According to some example embodiments of the present disclosure, the interposer 43 may include electrical connection elements 44 that electrically connect components (e.g., the solder joints 52) on the top surface of the interposer 43 to components (e.g., the solder joints 50) on the bottom surface of the interposer 43. The electrical connection elements 44 may be vias such as, for example, through silicon vias (TSVs).

According to some example embodiments of the present disclosure, the interposer 43 may be an integrated stack capacitor (ISC) Si interposer. The interposer 43 (e.g., an ISC Si interposer) may be configured for power and signal connections between components (e.g., the voltage regulator 42 and the first semiconductor chip 41), and may include an integrated stack capacitor.

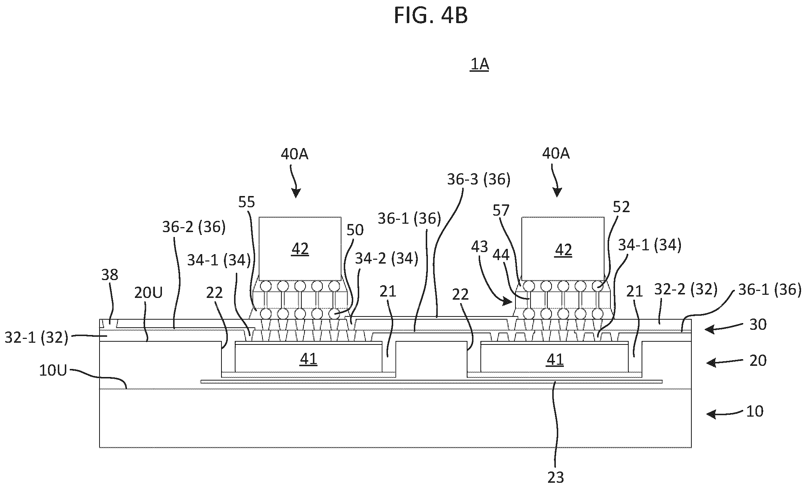

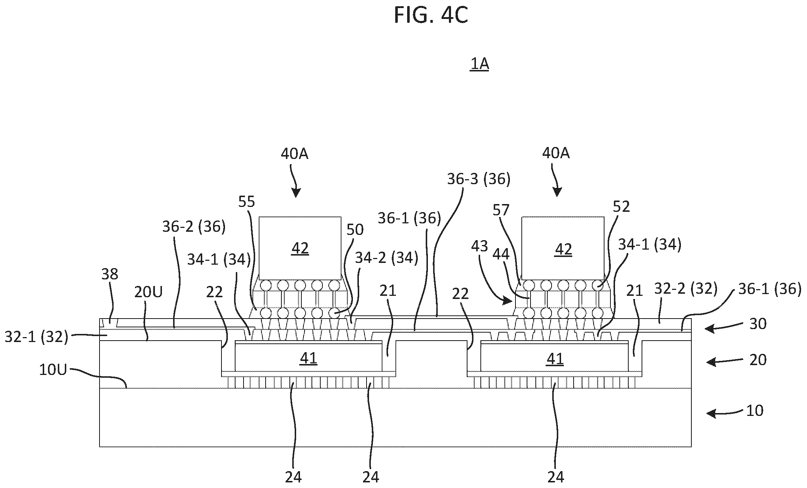

With reference to FIGS. 4B-C, the semiconductor device 1A may further include one or both from among the liquid cooling channels 23 (see FIG. 4B) and the thermal vias 24 (see FIG. 4C), which are described above with respect to FIGS. 3B-C.

For example, with reference to FIG. 4B, the substrate 20 of the semiconductor device 1A may include at least one liquid cooling channel 23. The at least one liquid cooling channel 23 may be configured to improve thermal management performance of the semiconductor device 1A by, for example, transferring heat away from the semiconductor assemblies 40 (e.g., the first semiconductor chips 41). For example, the least one liquid cooling channel 23 may be configured to have a liquid (e.g., water) flow therein to receive heat, thereby cooling the semiconductor assemblies 40 (e.g., the first semiconductor chips 41). For example, the liquid cooling channel 23 may be provided underneath at least one of the first semiconductor chips 41 that are within the recesses 22. For example, the liquid cooling channel 23 may extend in at least one horizontal direction underneath at least one of the first semiconductor chips 41. For example, one liquid cooling channel 23 may extend underneath at least two of the first semiconductor chips 41 of at least two semiconductor assemblies 40, but embodiments of the present disclosure are not limited thereto.

For example, with reference to FIG. 4C, the substrate 20 of the semiconductor device 1A may alternatively or additionally include thermal vias 24. The thermal vias 24 may be configured to improve thermal management performance of the semiconductor device 1A by, for example, transferring heat away from the semiconductor assemblies 40 (e.g., the first semiconductor chips 41). For example, the thermal vias 24 may extend vertically through at least a portion of the substrate 20 transfer heat from the semiconductor assemblies 40 (e.g., the first semiconductor chips 41) to the liquid cooling cold plate 10. For example, top surfaces of the thermal vias 24 may be coplanar with bottom surfaces of the recesses 22, and bottom surfaces of the thermal vias 24 may be coplanar and in direct contact with the liquid cooling cold plate 10. According to some example embodiments of the present disclosure, a set of the thermal vias 24 may be respectively provided underneath one or more (e.g., all) of the recesses 22.

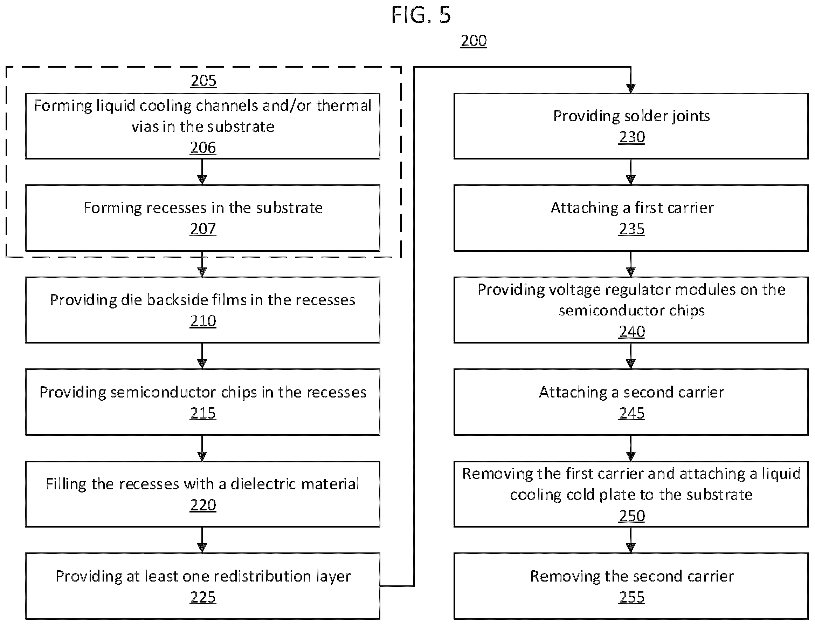

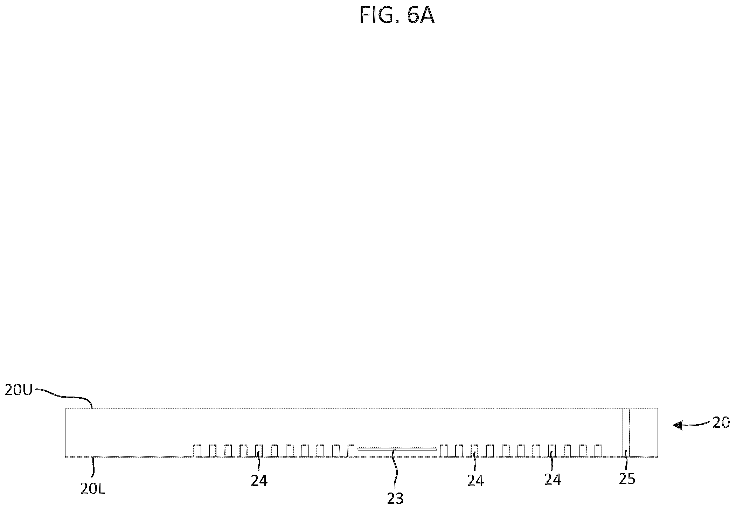

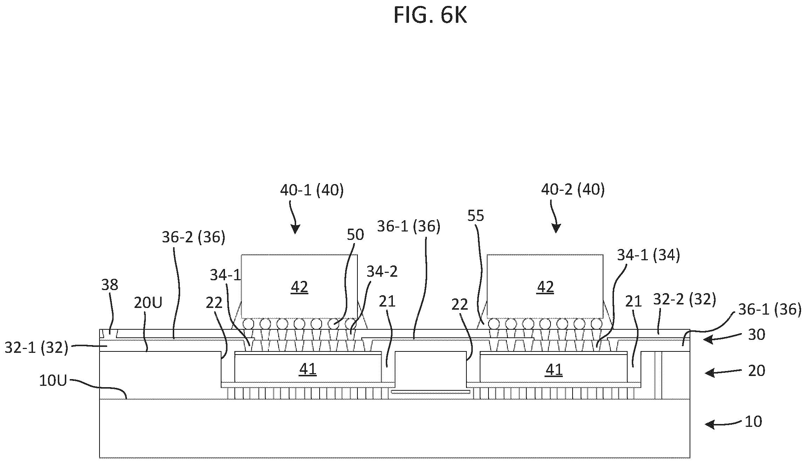

With reference to FIGS. 5-6K, a method 200 of manufacturing a semiconductor device may be provided. FIG. 5 illustrates a flowchart for the method 200 of manufacturing the semiconductor device according to an example embodiment of the present disclosure. FIGS. 6A-J illustrate intermediate semiconductor devices formed in operations of the method 200 of FIG. 5, according to example embodiments of the present disclosure. FIG. 6K illustrates a semiconductor device manufactured in an operation of the method 200 of FIG. 5, according to an example embodiment of the present disclosure. According to some example embodiments of the present disclosure, the semiconductor device manufactured in the method 200 may be the semiconductor device 1 as described above with respect to FIGS. 1-3C.

With reference to FIGS. 5 and 6A-B, the method 200 may include forming the substrate 20 (operation 205).

With reference to FIGS. 5 and 6A, operation 205 may include forming liquid cooling channels 23 and/or thermal vias 24 (operation 206). For example, in operation 206, the liquid cooling channels 23 described above with respect to FIG. 3B may be formed and/or the thermal vias 24 described above with respect to FIG. 3C may be formed. Alternatively or additionally, at least one thermal through via 25 may be formed to extend from the top surface 20U to the bottom surface 20L of the substrate 20.

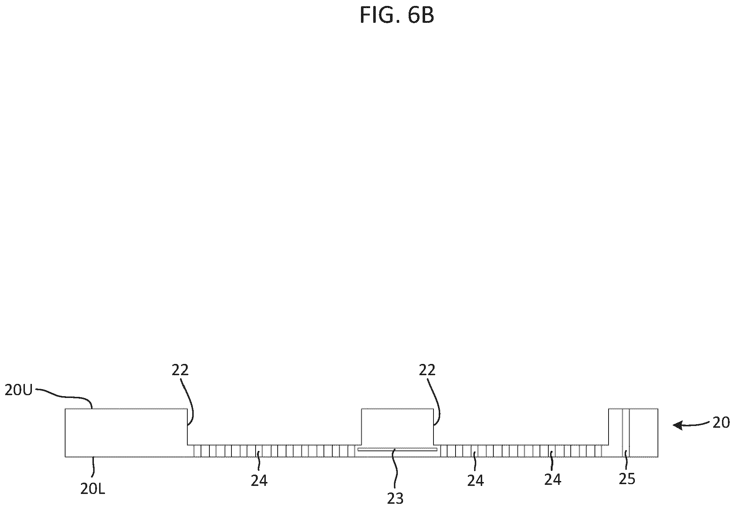

Although a liquid cooling channel 23 is illustrated in FIG. 6A to substantially extend in only a region between two sets of thermal vias 24, that are to be below respective recesses 22 of the substrate 20 (see FIG. 6B), embodiments of the present disclosure are not limited thereto. For example, the liquid cooling channel 23 may have various configurations, including configurations described above with reference to FIG. 3B.

According to some example embodiments of the present disclosure, at least one thermal through via 25 may be provided (e.g., formed) at a side of where one of the recesses 22 may be formed (see FIG. 6B) in operation 205. The thermal through vias 25 may be configured to improve thermal management performance of the semiconductor device by, for example, transferring heat away from portions of semiconductor device to the liquid cooling cold plate 10 (to be later provided).

According to some example embodiments of the present disclosure, the substrate 20, including the liquid cooling channels 23, the thermal vias 24, and/or the thermal through vias 25 may be formed through panel-level or wafer-level processes including, for example, (a) laser, wet etching, (b) Cu plating, etc.

According to some example embodiments of the present disclosure, the liquid cooling channels 23, the thermal vias 24, and/or the thermal through vias 25 may not be provided in the substrate 20.

With reference to FIGS. 5 and 6B, operation 205 may include forming the recesses 22 (e.g., cavities) in the top surface 20U of the substrate 20 (operation 207). According to some example embodiments of the present disclosure, the recesses 22 may be formed via laser milling, wet etching, etc.

With reference FIGS. 5 and 6C, the method 200 may further include providing die backside films 26 on the bottom surface of each of the recesses 22 (operation 210). According to some example embodiments of the present disclosure, the die backside films 26 may be laminated on the bottom surface of each of the recesses 22.

With reference FIGS. 5 and 6D, the method 200 may further include providing the first semiconductor chips 41 in the recesses 22 (operation 215). For example, each of the first semiconductor chips 41 may be embedded in a respective one of the recesses 22, on a top surface of the die backside film 26 in the recess 22. According to some example embodiments of the present disclosure, the operation 215 may include picking up "test-good" semiconductor chip (e.g., ASICs or memory chips) and embedding them in respective ones of the recesses 22 as the first semiconductor chips 41. That is, only semiconductor chips determined to be non-defective may be used as the first semiconductor chips 41.

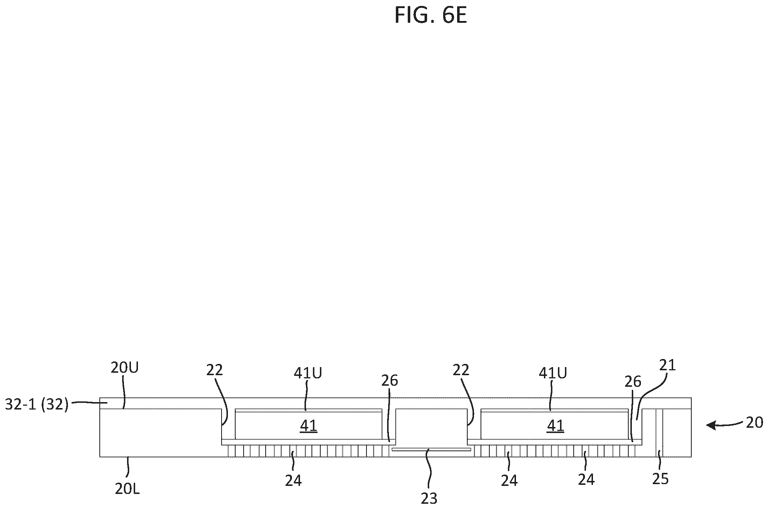

With reference FIGS. 5 and 6E-F, the method 200 may further include filling the recesses 22 with the dielectric material 21 (operation 220), providing the at least one RDL 30 (operation 225), and providing the solder joints 50 (operation 230).

For example, with reference to FIG. 6E, a build-up film lamination process or a polyimide (PI) dry film lamination process may be performed such that the dielectric material 21 fills the gaps inside the recesses 22, and the lowermost dielectric layer 32-1, among dielectric layers 32 to be formed, is provided directly on the top surface 20U of the substrate 20. According to some example embodiments of the present disclosure, the dielectric layers 32 may be formed integrally with the dielectric material 21 by the build-up film lamination process or the polyimide (PI) dry film lamination process.

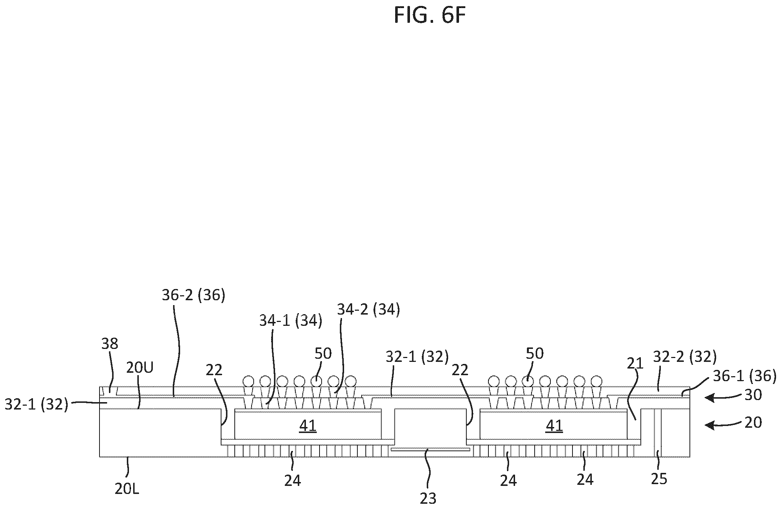

With reference to FIG. 6F, after the dielectric material 21 is provided and the lower lowermost dielectric layer 32-1 is formed, the traces 36 (e.g., the first traces 36-1, the second traces 36-2, and/or the third traces 36-3 (see FIG. 3A), the vias 34 (e.g., the first vias 34-1 and/or the second vias 34-2), the pads 38, additional dielectric layers 32 (e.g., the uppermost dielectric layer 32-2), and/or the solder joints 50 may be formed by using processes such as, for example, lamination, lithography, plating, stripping, etc.

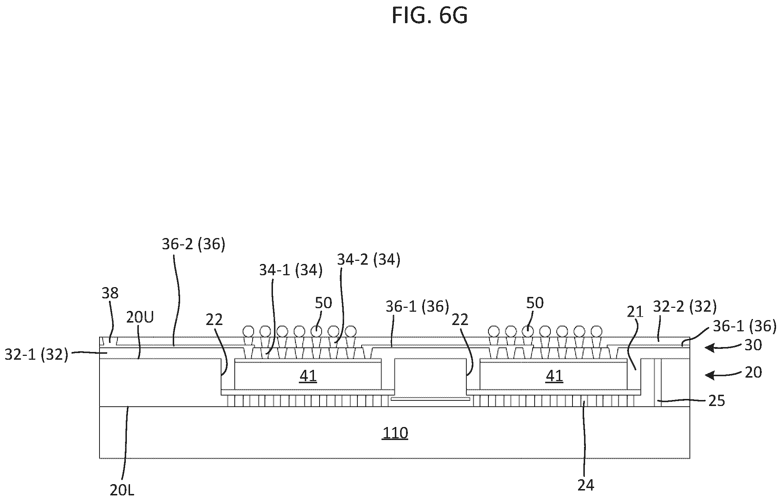

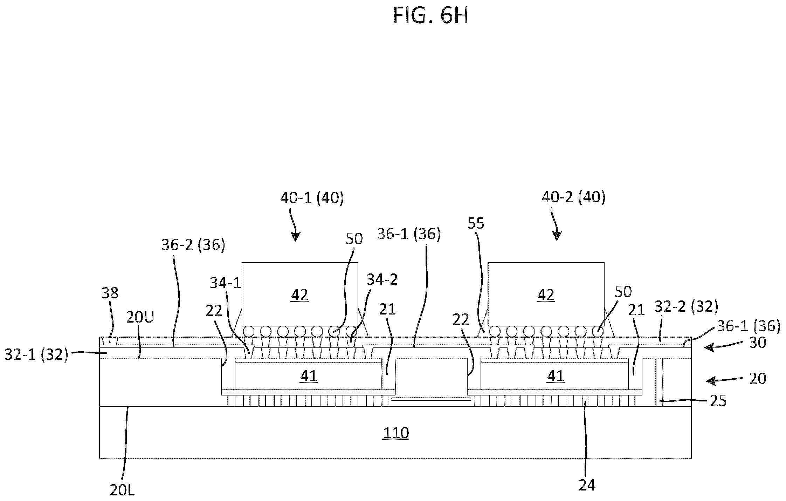

With reference to FIGS. 5 and 6G, the method 200 may further include attaching a first carrier 110 on the bottom surface 20L of the substrate 20 (operation 235). For example, the first carrier 110 may be a panel-scale or wafer-scale carrier that has a size to support an entirety of the substrate 20 (e.g., a panel-scale or wafer-scale substrate that may be formed of Si or glass). For example, the size of the first carrier 110, in a plan view (see FIG. 1) may be the same or similar to the size of the substrate 20 in the plan view. Because of the weight of multiple voltage regulators 42 (see FIG. 6H) to be provided in the semiconductor device may be too heavy for the substrate 20, the first carrier 110 may be attached to the bottom surface 20L of the substrate 20 to provide mechanical support for assembly of the voltage regulators 42 in the semiconductor device.

With reference to FIGS. 5 and 6H, the method 200 may further include providing the voltage regulators 42 on the first semiconductor chips 41 (operation 240). For example, the voltage regulators 42 may be provided to respectively overlap the first semiconductor chips 41 (and the recesses 22) in the vertical direction. For example, the voltage regulators 42 may be connected to the solder joints 50 on the top surface of the at least one RDL 30 by, for example, a chip-on-wafer (CoW) thermal compressive bonding (TCB) or a panel-level or wafer-level solder mass reflow process.

According to some example embodiments of the present disclosure, operation 240 may further include providing underfill 55 to surround the solder joints 50 and a lower portion of the voltage regulators 42. The underfill 55 may help to prevent mechanical damage and improve reliability performance of the solder joints 50. A non-conductive film (NCF) may be applied as the underfill 55 during the TCB process. Alternatively, the underfill 55 may be an epoxy-flux material that is applied to the solder joints 50 (e.g., solder bumps) before the panel-level or wafer-level solder mass reflow process, such that the underfill 55 surrounds the solder joints 50.

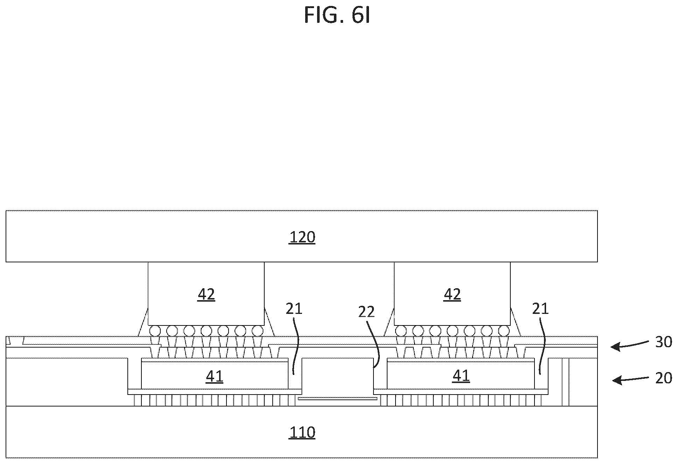

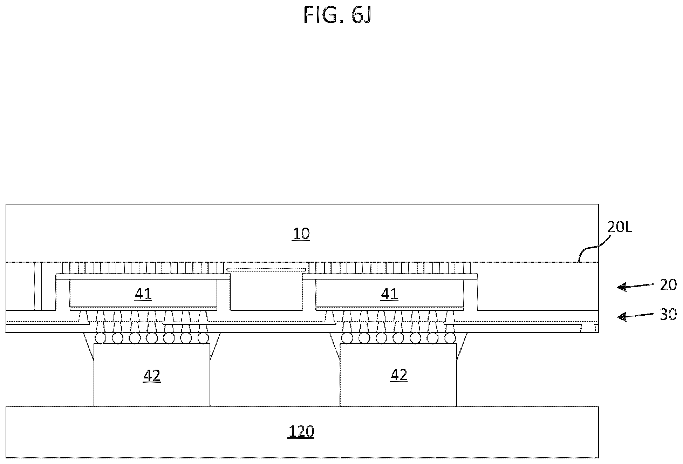

With reference to FIGS. 5 and 6I, the method 200 may further include attaching a second carrier 120 onto the top surface of the voltage regulators 42 (operation 245). For example, the second carrier 120 may be attached to the top surfaces of the voltage regulators 42 to provide mechanical support for when the liquid cooling cold plate 10 is attached (see FIG. 6J). According to some example embodiments of the present disclosure, the second carrier 120 may be a panel-scale or wafer-scale carrier that has a same or similar size, in a plan view (see FIG. 1) as a size of the first carrier 110 in the plan view.

With reference to FIGS. 5 and 6J, the method 200 may further include removing the first carrier 110 and attaching the liquid cooling cold plate 10 on the bottom surface 20L of the substrate 20 (operation 250). According to some example embodiments of the present disclosure, operation 250 may include flipping over the intermediate semiconductor device such that the bottom surface 20L of the substrate 20 faces upwards, and then removing the first carrier 110 and attaching the liquid cooling cold plate 10 on the bottom surface 20L of the substrate 20 (which may be facing upwards).

With reference to FIGS. 5 and 6K, the method 200 may further include removing the second carrier 120 (operation 255). For example, operation 255 may include flipping back over the semiconductor device such that the bottom surface 20L of the substrate 20 is facing downwards, and then removing the second carrier 120 from the bottom surface 20L of the substrate 20.

By performing the method 200, the semiconductor device of FIG. 6K (or the semiconductor device 1 of FIGS. 1-3C) may be manufactured.

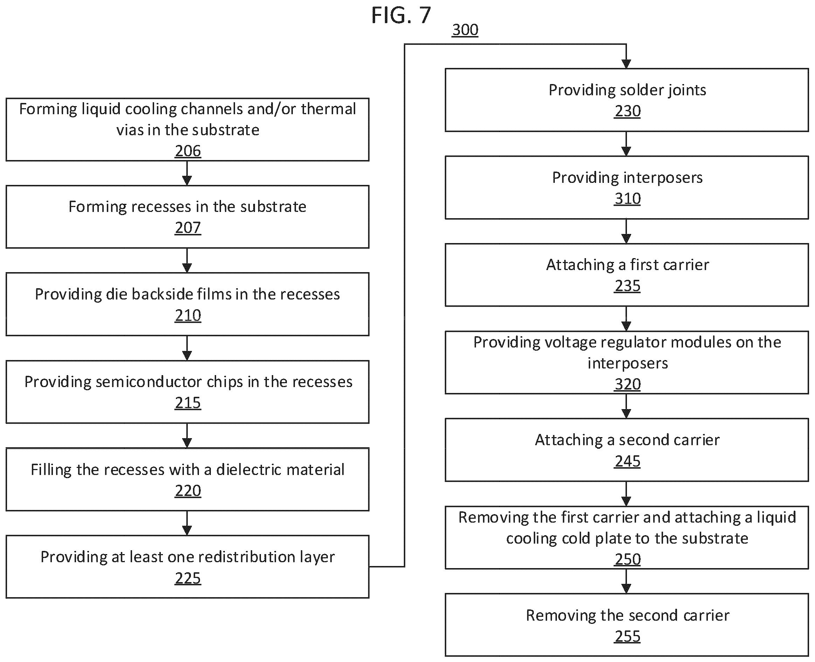

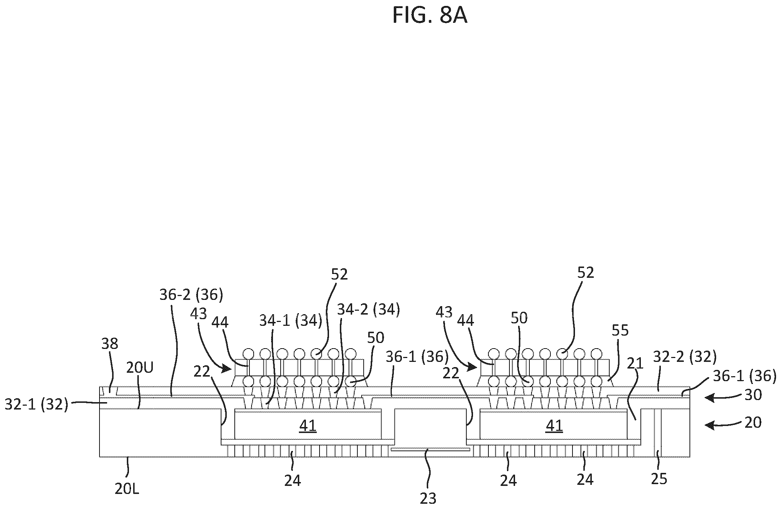

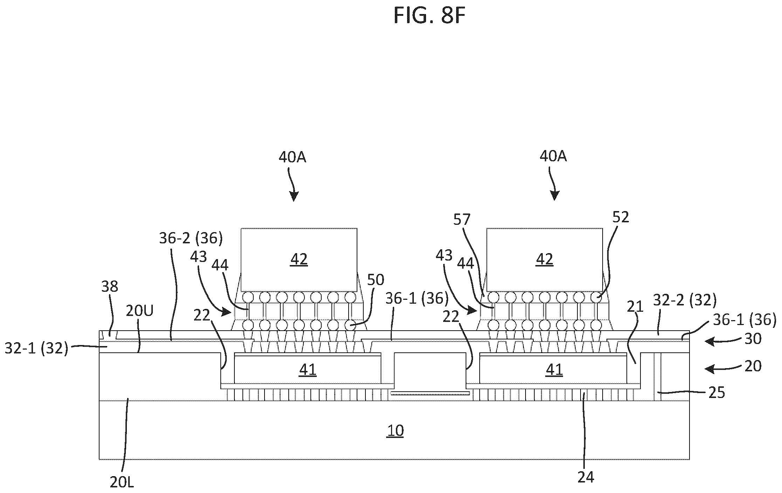

With reference to 7-8E, a method 300 of manufacturing a semiconductor device may be provided. FIG. 7 illustrates a flowchart for the method 300 of manufacturing the semiconductor device according to an example embodiment of the present disclosure. FIGS. 8A-E illustrate intermediate semiconductor devices formed in operations of the method 300 of FIG. 7, according to example embodiments of the present disclosure. FIG. 8F illustrates a semiconductor device manufactured in an operation of the method 300 of FIG. 7, according to an example embodiment of the present disclosure. According to some example embodiments of the present disclosure, the semiconductor device manufactured in the method 300 may be the semiconductor device 1A as described above with reference to FIGS. 4A-C.

According to some embodiments of the present disclosure, the method 300 may include the operations 205-230 as described above with reference to FIGS. 5-6F. Accordingly, repeated descriptions of operations 205-230 may be omitted.

With reference to FIGS. 7 and 8A, after operation 230, the method 300 may include providing the interposers 43 on the first semiconductor chips 41 for each of the semiconductor assemblies 40A to be formed (operation 310). For example, each interposer 43 may be connected to solder joints 50 on the top surface of the at least one RDL 30 such as to be connected to a respective one of the first semiconductor chips 41 by at least one of the first vias 34-1, at least one of the second vias 34-2, and the solder joints 50. For example, the interposers 43 may be provided to respectively overlap the first semiconductor chips 41 (and the recesses 22) in the vertical direction. For example, the interposers 43 may be connected to the solder joints 50 on the top surface of the at least one RDL 30 by, for example, a chip-on-wafer (CoW) thermal compressive bonding (TCB) or a panel-level or wafer-level solder mass reflow process.

According to some example embodiments of the present disclosure, operation 310 may further include providing underfill 55 to surround the solder joints 50. The underfill 55 may help to prevent mechanical damage and improve reliability performance of the solder joints 50. A non-conductive film (NCF) may be applied as the underfill 55 during the TCB process. Alternatively, the underfill 55 may be an epoxy-flux material that is applied to the solder joints 50 (e.g., solder bumps) before the panel-level or wafer-level solder mass reflow process, such that the underfill 55 surrounds the solder joints 50.

According to some example embodiments of the present disclosure, the solder joints 52 may be on an upper surface of the interposers 43 before and when the interposers 43 are connected to the solder joints 50. Alternatively, the solder joints 52 may be provided to the upper surfaces of the interposers 43 after the interposers 43 are connected to the solder joints 50.

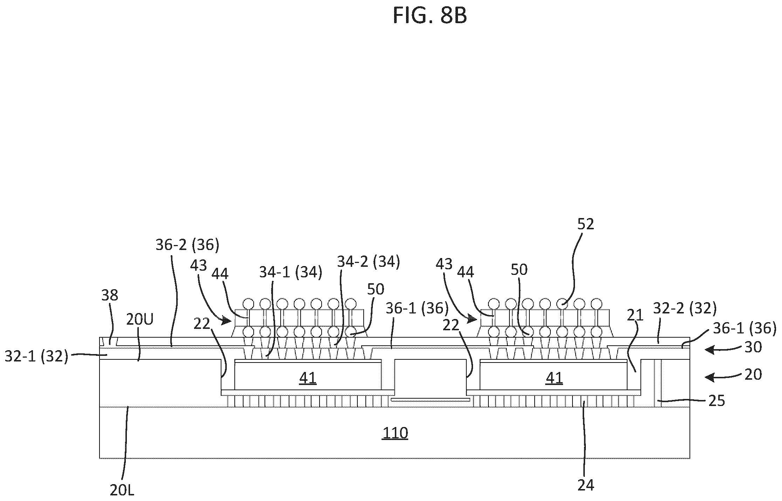

With reference to FIGS. 7 and 8B, after operation 310, the method 300 may include attaching the first carrier 110 on the bottom surface 20L of the substrate 20 (operation 235), which may be substantially the same as described above with reference to FIGS. 5 and 6G. Accordingly, repeated descriptions of operation 235 may be omitted.

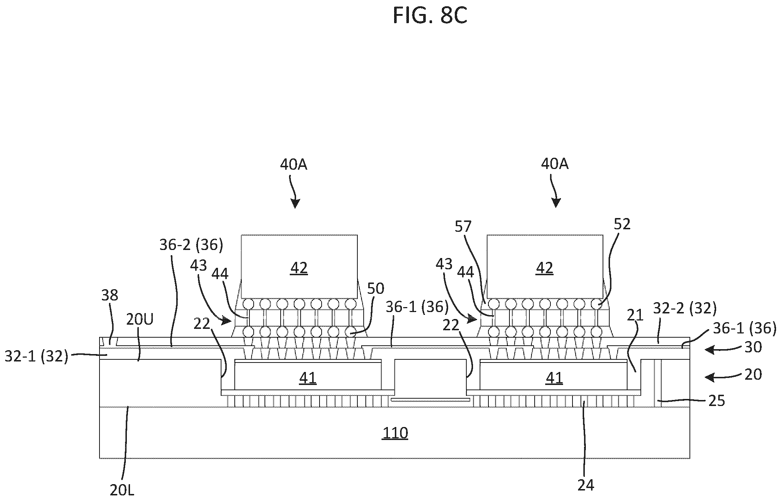

With reference to FIGS. 7 and 8C, after operation 235, the method 300 may include providing the voltage regulators 42 on the interposers 43 (operation 320). For example, the voltage regulators 42 may be provided to respectively overlap the interposers 43 (and the first semiconductor chips 41 and the recesses 22) in the vertical direction. For example, the voltage regulators 42 may be connected to the solder joints 52 on the top surface of the interposers 43 by, for example, a chip-on-wafer (CoW) thermal compressive bonding (TCB) or a panel-level or wafer-level solder mass reflow process.

According to some example embodiments of the present disclosure, operation 320 may further include providing underfill 57 to surround the solder joints 52 and a lower portion of the voltage regulators 42. The underfill 57 may help to prevent mechanical damage and improve reliability performance of the solder joints 52. A non-conductive film (NCF) may be applied as the underfill 57 during the TCB process. Alternatively, the underfill 57 may be an epoxy-flux material that is applied to the solder joints 52 (e.g., solder bumps) before the panel-level or wafer-level solder mass reflow process, such that the underfill 57 surrounds the solder joints 52.

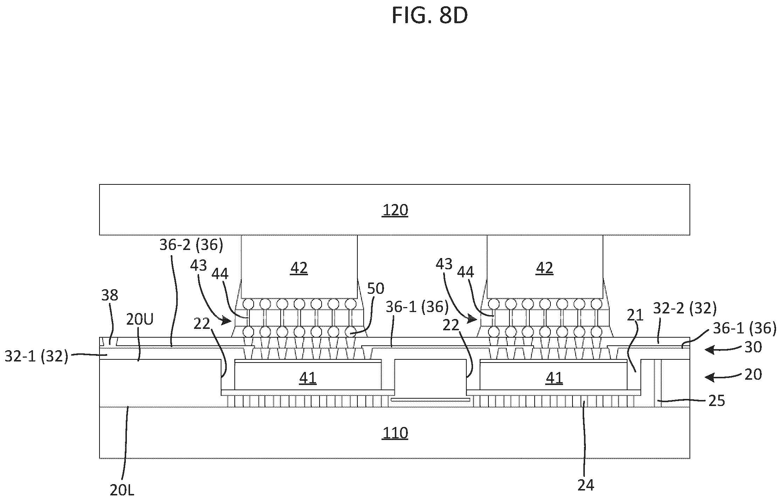

With reference to FIGS. 7 and 8D, the method 300 may further include attaching a second carrier 120 onto the top surface of the voltage regulators 42 (operation 245), which may be substantially the same as described above with reference to FIGS. 5 and 6I. Accordingly, repeated descriptions of operation 245 may be omitted.

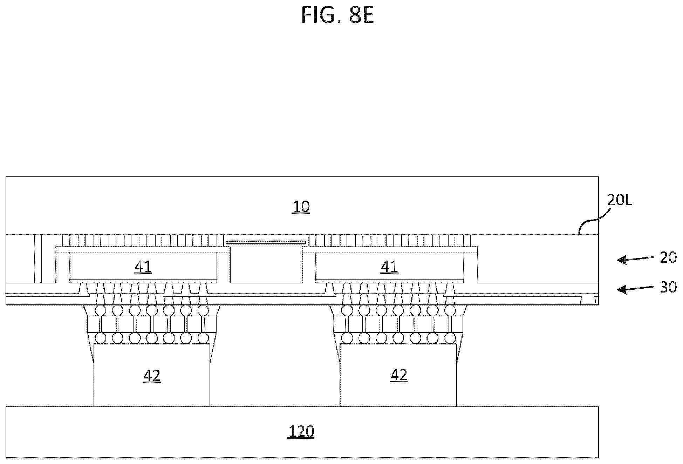

With reference to FIGS. 7 and 8E, the method 300 may further include removing the first carrier 110 and attaching the liquid cooling cold plate 10 on the bottom surface 20L of the substrate 20 (operation 250), which may be substantially the same as described above with reference to FIGS. 5 and 6J. Accordingly, repeated descriptions of operation 250 may be omitted.

With reference to FIGS. 7 and 8F, the method 200 may further include removing the second carrier (operation 255), which may be substantially the same as described above with reference to FIGS. 5 and 6K. Accordingly, repeated descriptions of operation 255 may be omitted.

By performing the method 300, the semiconductor device of FIG. 8F (or the semiconductor device 1A of FIGS. 4A-C) may be manufactured.

As described above, the interposers 43 may be provided (e.g., attached) on the first semiconductor chips 41 for each of the semiconductor assemblies 40A to be formed (operation 310) before attaching the voltage regulators 42 onto the interposers 43 (operation 320). However, embodiments of the present disclosure are not limited thereto.

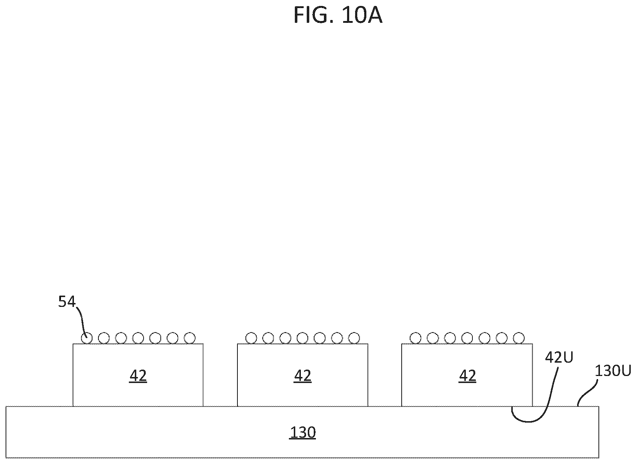

For example, the voltage regulators 42 may be respectively attached onto the interposers 43 to form voltage regulation assemblies 140 (see FIGS. 10A-C) and the voltage regulation assemblies 140 may then be attached on the first semiconductor chips 41, respectively.

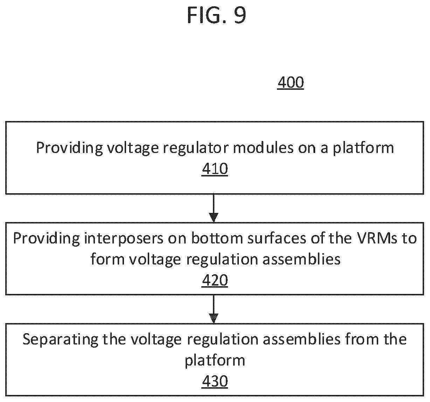

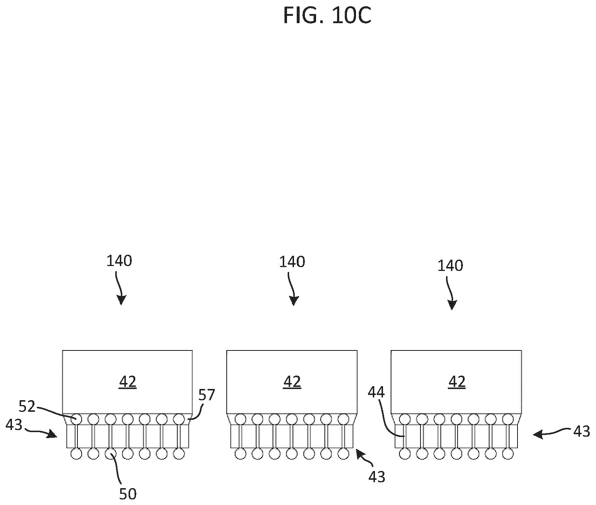

For example, with reference to FIGS. 9-10C, a method 400 of manufacturing the voltage regulation assemblies 140 may be provided. FIG. 9 illustrates a flowchart for the method 400 of manufacturing the voltage regulation assemblies 140 according to an example embodiment of the present disclosure. FIGS. 10A-B respectively illustrate intermediate voltage regulation assemblies formed in operations of the method of FIG. 9, according to example embodiments of the present disclosure. Fig. 10 C illustrates the voltage regulation assemblies 140 manufactured in an operation of the method of FIG. 9, according to an example embodiment of the present disclosure.

With reference to FIGS. 9 and 10A, the method 400 may include providing the voltage regulators 42 on a platform 130 (operation 410). For example, one or more voltage regulators 42 (e.g., three voltage regulators 42) may be picked up and placed up-side down on a top surface 130U of the platform 130. For example, top surfaces 42U (which may be called bottom surfaces with reference to FIG. 10A) of the one or more voltage regulators 42 may be attached to the top surface 130U of the platform 130. According to some example embodiments of the present disclosure, the platform 130 may be a carrier or a tray.

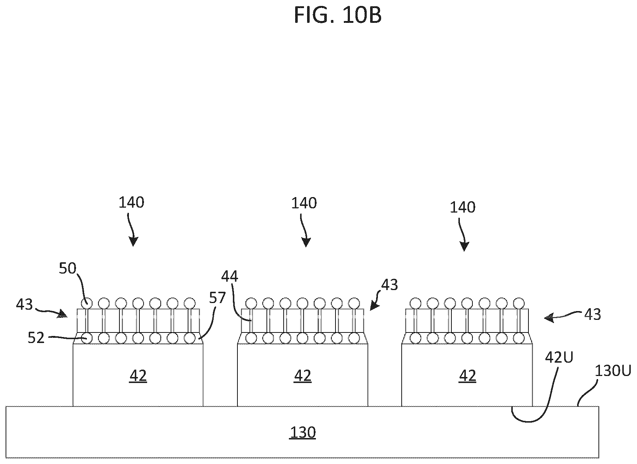

With reference to FIGS. 9 and 10B, the method 400 may further include providing the interposers 43 on the bottom surfaces (which may be called top surfaces with reference to FIG. 10B) of the voltage regulators 42 (operation 420). For example, the interposers 43 may be provided to respectively overlap the voltage regulators 42 in the vertical direction. For example, the interposers 43 may be connected to the solder joints 52 on the top surface of the voltage regulators 42 by, for example, a chip-on-wafer (CoW) thermal compressive bonding (TCB) or a panel-level or wafer-level solder mass reflow process.

According to some example embodiments of the present disclosure, operation 420 may further include providing underfill 57 to surround the solder joints 52. The underfill 57 may help to prevent mechanical damage and improve reliability performance of the solder joints 52. A non-conductive film (NCF) may be applied as the underfill 57 during the TCB process. Alternatively, the underfill 57 may be an epoxy-flux material that is applied to the solder joints 52 (e.g., solder bumps) before the panel-level or wafer-level solder mass reflow process, such that the underfill 57 surrounds the solder joints 52.

According to some example embodiments of the present disclosure, the solder joints 50 may be on a bottom surface (which may called a top surface in FIG. 10B) of the interposers 43 before and when the interposers 43 are connected to the solder joints 52. Alternatively, the solder joints 50 may be attached to the upper surfaces of the interposers 43 after the interposers 43 are connected to the solder joints 52.

By performing operations 410 and 420, the voltage regulation assemblies 140 may be substantially manufactured.

With reference to FIGS. 9 and 10C, the method 400 may further include separating the voltage regulation assemblies 140 from the platform 130 (operation 430). For example, operation 430 may include removing the platform 130 from the voltage regulation assemblies 140, or removing the voltage regulation assemblies 140 from the platform 130.

After the voltage regulation assemblies 140 are manufactured, the voltage regulation assemblies 140 may be tested and then assembled in semiconductor devices (e.g., a panel-scale or wafer-scale semiconductor device, circuit, etc.) according to some example embodiments of the present disclosure.

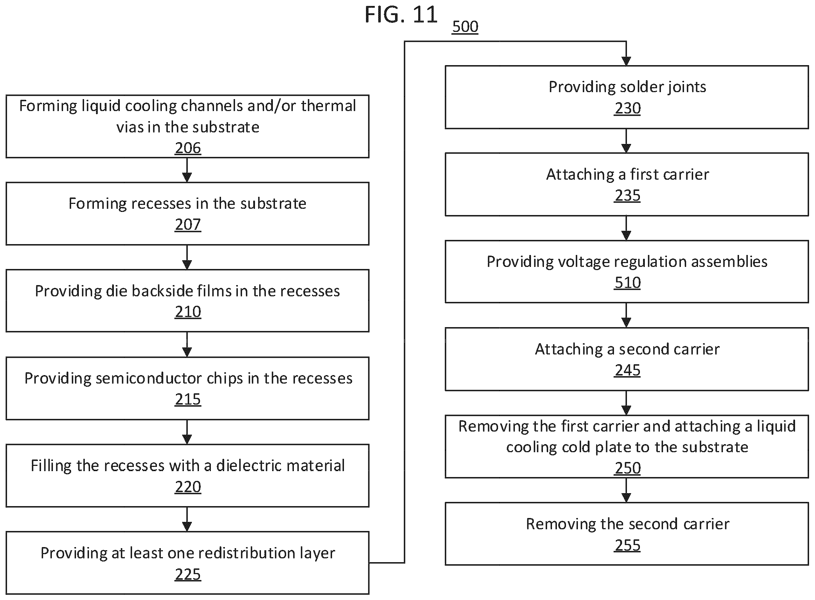

With reference to FIG. 11, a method 500 of manufacturing a semiconductor device may be provided that may incorporate the voltage regulation assemblies 140 manufactured in the method 400. FIG. 11 illustrates a flowchart for the method 500 of manufacturing the semiconductor device according to an example embodiment of the present disclosure.

According to some embodiments of the present disclosure, the method 500 may include the operations 205-230 as described above with reference to FIGS. 5-6G. Accordingly, repeated descriptions of operations 205-235 may be omitted.

With reference to FIGS. 11, after the intermediate semiconductor device of FIG. 6G is formed through operation 235, the method 500 may include providing the voltage regulation assemblies 140, manufactured in the method 400, on the first semiconductor chips 41 to form the semiconductor assembles 40A. For example, with reference to FIG. 8C, each voltage regulation assembly 140 (e.g., the interposer 43 thereof) may be connected by the solder joints 50 on the top surface of the at least one RDL 30 such as to be connected to a respective one of the first semiconductor chips 41 by at least one of the first vias 34-1 (see FIGS. 4A-C), at least one of the second vias 34-2 (see FIGS. 4A-C), and the solder joints 50. For example, the voltage regulation assemblies 140 may be provided to respectively overlap the first semiconductor chips 41 (and the recesses 22) in the vertical direction. For example, the voltage regulation assemblies 140 (e.g., the interposers 43 thereof) may be connected by the solder joints 50 on the top surface of the at least one RDL 30 by, for example, a chip-on-wafer (CoW) thermal compressive bonding (TCB) or a panel-level or wafer-level solder mass reflow process.

According to some example embodiments of the present disclosure, operation 510 may further include providing underfill 55 to surround the solder joints 50. The underfill 55 may help to prevent mechanical damage and improve reliability performance of the solder joints 50. A non-conductive film (NCF) may be applied as the underfill 55 during the TCB process. Alternatively, the underfill 55 may be an epoxy-flux material that is applied to the solder joints 50 (e.g., solder bumps) before the panel-level or wafer-level solder mass reflow process, such that the underfill 55 surrounds the solder joints 50.

After the operation 510 is performed such that, for example, the intermediate semiconductor device of FIG. 8C is manufactured, the operations 245, 250, and 255 may be performed, which may be substantially the same as described above with reference to FIGS. 7 and 8D-F. Accordingly, repeated descriptions of operation 245, 250, and 255 may be omitted.

By performing the method 500, the semiconductor device of FIG. 8F (or the semiconductor device 1A of FIGS. 4A-C) may be manufactured.

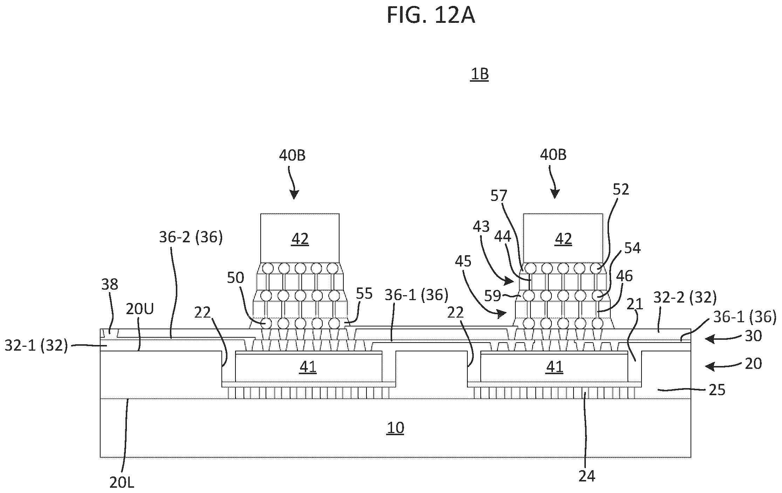

With reference to FIG. 12A, a semiconductor device 1B may be provided. FIG. 12A illustrates a schematic cross-sectional view showing the semiconductor device 1B according to example embodiments of the present disclosure. The semiconductor device 1B may be the same as or similar to the semiconductor device 1A described above with reference to FIGS. 4A-C, except that there may be differences with respect to semiconductor assemblies. Thus, repeated descriptions of the semiconductor device 1B may be omitted.

With reference to FIG. 12A, the semiconductor assemblies 40B may each further include a second semiconductor chip 45 (also referred to as a semiconductor die) between the first semiconductor chip 41 and the interposer 43. The second semiconductor chip 45 may further improve performance of the semiconductor device 1B. For example, the second semiconductor chip 45 may be any type of semiconductor chip. For example, the second semiconductor chip 45 may be an ASIC chip, a memory chip, FPGA, processor, coprocessor, etc.

According to some example embodiments of the present disclosure, the second semiconductor chip 45 may be provided on the top surface of the at least one RDL 30 such as to be electrically connected to the first semiconductor chip 41 by at least one of the first vias 34-1 (see FIGS. 4A-C), at least one of the second vias 34-2 (see FIGS. 4A-C), and the solder joints 50. Solder joints 54 may be provided between the second semiconductor chip 45 and the interposer 43, on a top surface of the second semiconductor chip 45. For example, the solder joints 54 may electrically connect the second semiconductor chip 45 to the interposer 43. Thus, the voltage regulator 42 may be electrically connected to the second semiconductor chip 45 of the same semiconductor assembly 40A by the solder joints 52, the interposer 43 (e.g., the electrical connection elements 44), and the solder joints 54, and may be configured to regulate voltage to the second semiconductor chip 45.

According to some example embodiments of the present disclosure, the solder joints 54 may be surrounded, in at least horizontal directions, by an underfill 59 that is on the upper surface of the second semiconductor chip 45. For example, underfills 59 may be provided to respectively correspond to each of the second semiconductor chips 45, such that a respective underfill 59 surrounds the solder joints 54 on each of the second semiconductor chips 45. The underfills 59 may be configured to protect the solder joints 54 from mechanical and reliability failures. According to some example embodiments of the present disclosure, a non-conductive film (NCF) may be applied as the underfill 59 during a TCB process. Alternatively, the underfill 59 may be an epoxy-flux material that is applied to the solder joints 54.

According to some example embodiments of the present disclosure, the second semiconductor chip 45 may include electrical connection elements 46 that electrically connect components (e.g., the solder joints 54) on the top surface of the second semiconductor chip 45 to components (e.g., the solder joints 50) on the bottom surface of the second semiconductor chip 45. Thus, the voltage regulator 42 may be electrically connected to the first semiconductor chip 41 of the same semiconductor assembly 40A by the solder joints 52, the interposer 43 (e.g., the electrical connection elements 44), the solder joints 54, the second semiconductor chip 45 (e.g., the electrical connection elements 46), the solder joints 50, at least one of the second vias 34-2 (see FIGS. 4A-C), and at least one of the first vias 34-1 (see FIGS. 4A-C), and may be configured to regulate voltage to the first semiconductor chip 41.

According to some example embodiments of the present disclosure, the electrical connection elements 46 may be vias such as, for example, through silicon vias (TSVs). Also, the electrical connection elements 46 may be configured for power and/or signal connections.

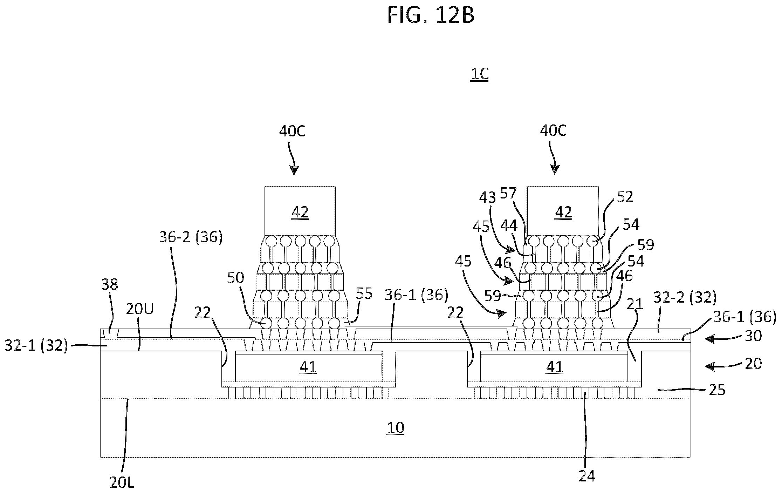

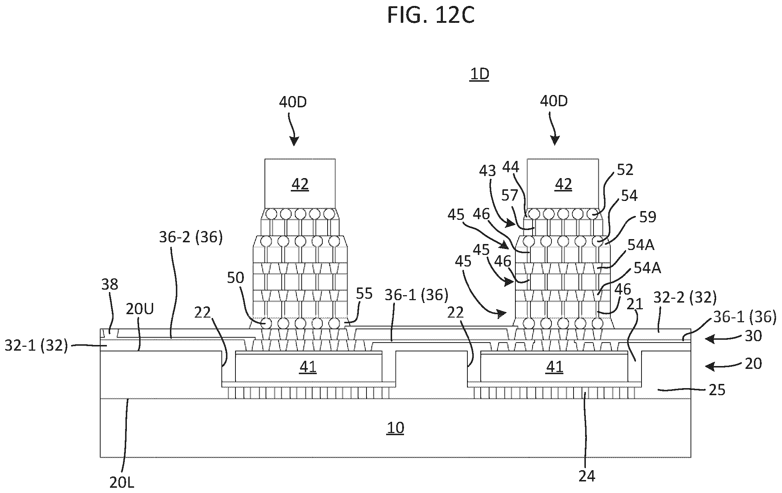

According to some example embodiments of the present disclosure, with reference to FIGS. 12B-C, a plurality of the second semiconductor chip 45 (e.g., two or more) may be provided in each of the semiconductor assemblies, which may further improve performance of the semiconductor device. FIG. 12B illustrates a schematic cross-sectional view showing a semiconductor device 1C according to an example embodiment of the present disclosure. FIG. 12C illustrates a schematic cross-sectional view showing a semiconductor device 1D according to an example embodiment of the present disclosure. The semiconductor device 1C and the semiconductor device 1D may be the same as or similar to the semiconductor device 1B described above with reference to FIG. 12A, except that there may be differences with respect to semiconductor assemblies. Thus, repeated descriptions of the semiconductor device 1C and the semiconductor device 1D may be omitted.

With reference to FIG. 12B, the semiconductor assemblies 40C may each include two second semiconductor chips 45 that are stacked between the first semiconductor chip 41 and the interposer 43. Also, with reference to FIG. 12C, the semiconductor assemblies 40D may each include three second semiconductor chips 45 that are stacked between the first semiconductor chip 41 and the interposer 43.

According to some example embodiments of the present disclosure, the two or more second semiconductor chips 45 of a same semiconductor assembly (e.g., the semiconductor assembly 40B or the semiconductor assembly 40C) may be electrically connected to the voltage regulator 42 of the same semiconductor assembly (e.g., the semiconductor assembly 40B or the semiconductor assembly 40C). According to some example embodiments of the present disclosure, the voltage regulator 42 may be configured to regulate voltage to the two or more second semiconductor chips 45 and the first semiconductor chip 41 of a same semiconductor assembly (e.g., the semiconductor assembly 40B or the semiconductor assembly 40C).

Additionally, with reference to FIG. 12B, sets of solder joints 54 may be provided on a top surface of each of the second semiconductor chips 45 to connect the second semiconductor chip 45 to a component there above (e.g., another second semiconductor chip 45 or the interposer 43), and each set of solder joints 54 may be surrounded by a respective one of the underfills 59.

According to some example embodiments of the present disclosure, the solder joints 54 may be micro bumps, and the second semiconductor chips 45 may be bonded to other second semiconductor chips 45 and/or the interposer 43 via a TCB technique using the solder joints 54. For example, with reference to FIG. 12B, the second semiconductor chips 45 may be bonded to other second semiconductor chips 45 and the interposer 43 via a TCB technique using the solder joints 54.

Alternatively, with reference to FIG. 12C, the underfills 59 and the solder joints 54 may not be provided between adjacent ones of the second semiconductor chips 45 within a same semiconductor assembly (e.g., the semiconductor assembly 40C or the semiconductor assembly 40D). For example, instead of using solder-based micro bumps and underfill materials, the adjacent ones of the second semiconductor chips 45 within a same semiconductor assembly (e.g., the semiconductor assembly 40C or the semiconductor assembly 40D) may be bonded (and electrically connected) together by copper-to-copper bonds 54A by performing a hybrid copper bonding (HCB) technique.

According some example embodiments of the present discourse, the semiconductor device 1B, the semiconductor device 1C, and/or the semiconductor device 1D may be manufactured by the method 300 of FIG. 7, wherein an additional operation of stacking and bonding at least one second semiconductor chip 45 within each semiconductor assembly is performed between the operation 230 (providing the solder joints 50) and the operation 310 (providing the interposers 43).

Alternatively, the semiconductor device 1B, the semiconductor device 1C, and/or the semiconductor device 1D may be manufactured by the method 500 of FIG. 11. For example, the voltage regulation assemblies that are provided in operation 510 may each include one or more second semiconductor chips 45, the interposer 43, and the voltage regulator 42, and the voltage regulation assemblies may be manufactured in the method 400 of FIG. 9, wherein the operation 420 further includes providing one or more of the second semiconductor chips 45 on the bottom surfaces of each of the interposers 43.

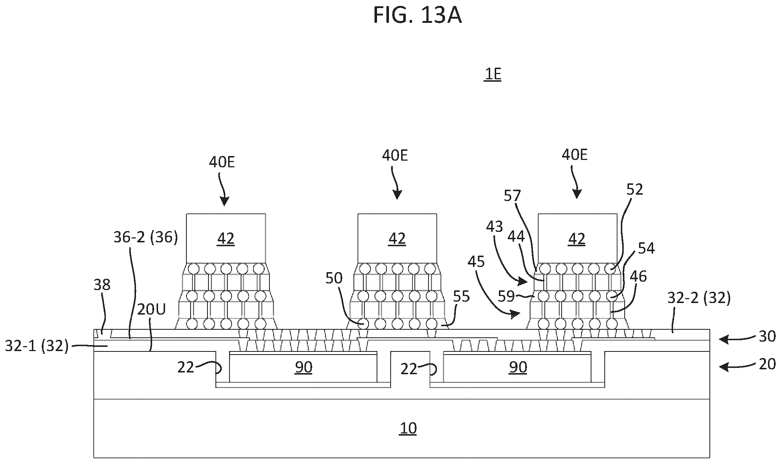

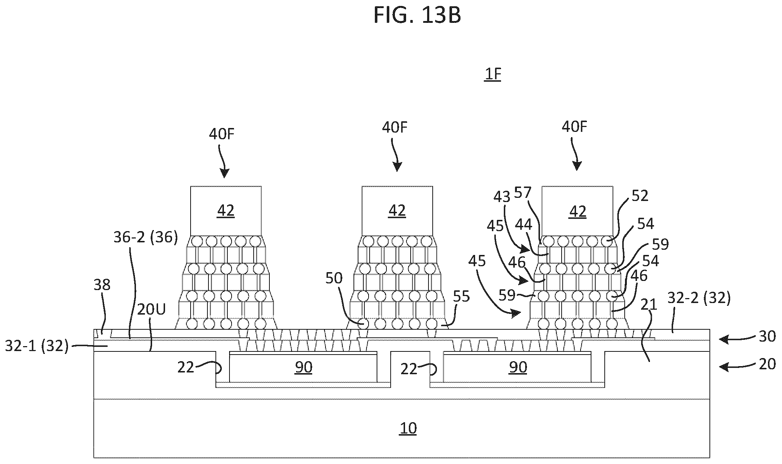

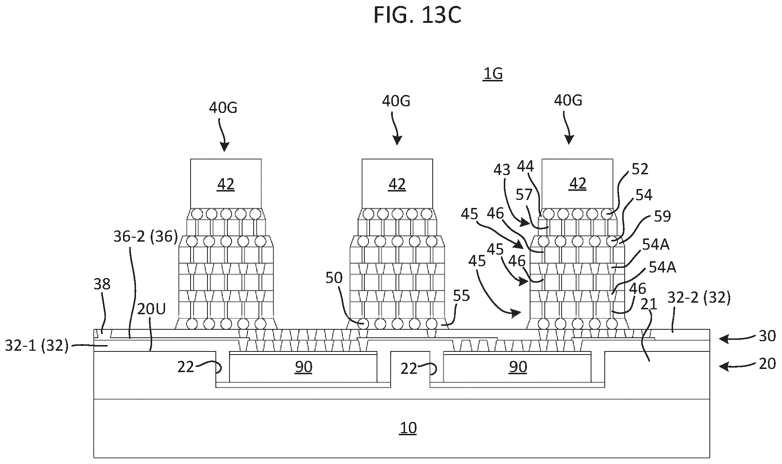

With reference to FIGS. 13A-C, a semiconductor device 1E including semiconductor assemblies 40E may be provided, a semiconductor device 1F including semiconductor assemblies 40F may be provided, and/or a semiconductor device 1G including semiconductor assemblies 40G may be provided. FIG. 13A illustrates a schematic cross-sectional view showing the semiconductor device 1E according to an example embodiment of the present disclosure. FIG. 13B illustrates a schematic cross-sectional view showing the semiconductor device 1F according to an example embodiment of the present disclosure. FIG. 13C illustrates a schematic cross-sectional view showing the semiconductor device 1G according to an example embodiment of the present disclosure.

The semiconductor device 1E, the semiconductor device 1F, and the semiconductor device 1G may be the same as or similar to the semiconductor device 1B, the semiconductor device 1C, and the semiconductor device 1D described above with reference to FIGS. 12A-C, except that there may be differences with respect to semiconductor assemblies. Thus, repeated descriptions of the semiconductor device 1E, the semiconductor device 1F, and the semiconductor device 1G may be omitted.

With reference to FIGS. 13A-C, the semiconductor assemblies (e.g., the semiconductor assemblies 40E, the semiconductor assemblies 40F, and the semiconductor assemblies 40G) may not include the first semiconductor chips 41. For example, the first semiconductor chips 41 may be replaced with bridge dies 90 that are respectively provided in the recesses 22 of the substrate 20. The recesses 22 (and the bridge dies 90) may be provided between adjacent ones of the semiconductor assemblies (e.g., the semiconductor assemblies 40E, the semiconductor assemblies 40F, and the semiconductor assemblies 40G). The bridge dies 90 may be embedded within the substrate 20 and may provide dense die-to-die connections. For example, each bridge die 90 may electrically connect together adjacent ones of the semiconductor assemblies (e.g., the semiconductor assemblies 40E, the semiconductor assemblies 40F, and the semiconductor assemblies 40G) that are adjacent to (e.g., overlapping with) the bridge die 90. The bridge die 90 may be electrically connected to the adjacent ones of the semiconductor assemblies (e.g., the semiconductor assemblies 40E, the semiconductor assemblies 40F, and the semiconductor assemblies 40G) through the vias and lines of the at least one RDL 30. According to some example embodiments of the present disclosure, the bridges dies 90 may be bridge chips.

According some example embodiments of the present discourse, the semiconductor device 1E, the semiconductor device 1F, and/or the semiconductor device 1G may be manufactured by the method 300 of FIG. 7, wherein (a) the operation 215 is changed to providing the bridge dies 90 within the recesses 22, and (b) an additional operation of stacking and bonding at least one second semiconductor chip 45 within each semiconductor assembly is performed between the operation 230 (providing the solder joints 50) and the operation 310 (providing the interposers 43).

Alternatively, the semiconductor device 1E, the semiconductor device 1F, and/or the semiconductor device 1G may be manufactured by the method 500 of FIG. 11, wherein the operation 215 is changed to providing the bridge dies 90 within the recesses 22. For example, the voltage regulation assemblies that are provided in operation 510 may each include one or more second semiconductor chips 45, the interposer 43, and the voltage regulator 42, and the voltage regulation assemblies may be manufactured in the method 400 of FIG. 9, wherein the operation 420 further includes providing one or more of the second semiconductor chips 45 on the bottom surfaces of each of the interposers 43.

Semiconductor devices (e.g., panel-scale and/or wafer-scale semiconductor devices, circuits, etc.) according to some example embodiments of the present disclosure may provide the following advantages.
(1) Numerous ASIC or memory chips, or FPGAs, processors, coprocessors, etc., (e.g., first semiconductor chips 41) are embedded in a panel-scale or wafer-scale glass or Si substrate (e.g., the substrate 20) with a dense RDL (e.g., the at least one RDL 30) providing die-to-die connection. Comparing with a wafer-scale device, circuit, etc., of a comparative embodiment generated from only a single wafer, this approach can dramatically improve yield. Additionally, semiconductor devices of some example embodiments of the present disclosure can be expanded to have a panel-scale, and may provide heterogeneous integration flexibility of having different types of ASIC or memory chips, or FPGAs, processors, coprocessors, etc., integrated into one panel-scale or wafer-scale device, circuit, etc.
(2) Comparing with an a system-on-wafer (SoW) made by integrated fan-out (InFO) wafer-level packaging, architectures according to some example embodiments of the present disclosure can be expanded from a wafer-scale to a panel-scale with a much larger size. Additionally, molding and mechanical grinding are eliminated in some example embodiments of the present disclosure, which may improve assembly yield and reliability performance of the embodiments.
(3) Panel-scale or wafer-scale Si or glass may be used as the substrate (e.g., the substrate 20), which may provide better mechanical support, less warpage, better reliability, and much larger packages, in comparison with some organic packages. Additionally, Si and glass have superior material properties compared with organic substrates. For example, Si and glass can survive high temperatures and humidity, provide better performance in high frequency applications, and better reliability in hash use conditions.
(4) The invention the present disclosure includes liquid cooling channels (e.g., liquid cooling channels 23) and may include thermal vias (e.g., thermal vias 24 and/or thermal through vias 25) inside the Si or glass substrate (e.g., the substrate 20), as well as a liquid cooling plate (e.g., the liquid cooling cold plate 10) at the backside of the substrate (e.g., the substrate 20), thereby greatly improving thermal management performance.
(5) Some example embodiments of the present discourse may include VRMs (e.g., voltage regulators 42) on top of one or more ASIC or memory chips, or FPGAs, processors, coprocessors, etc., (e.g., the first semiconductor chips 41 and/or the second semiconductor chips 45) such that the distance of PDN may be shortened, and PI performance may be improved.
(6) Some example embodiments of the present disclosure may include an ISC Si interposer (e.g., the interposer 43), which may include an Si capacitor with high capacitance density located very close to each ASIC or memory chip, or FPGAs, processors, coprocessors, etc., (e.g., the first semiconductor chips 41 and/or the second semiconductor chips 45) which may further improve PDN performance and may reduce the system power consumption.

According to some example embodiments of the present disclosure, the semiconductor devices may be applied to, for example, the following applications:
(1) AI training, CPU, GPU, and other ASIC applications that are in need of high power, high performance, and/or large packages.
(2) Automotive, radio-frequency (RF) chips, or aerospace applications that operate at high frequencies requiring higher reliability at hash use conditions.
(3) Data center applications demanding larger packages.

The present disclosure is presented to enable one of ordinary skill in the art to make and use the present disclosure and to incorporate it in the context of particular applications. While the foregoing is directed to specific examples, other and further examples may be devised without departing from the scope of the present disclosure.

Various modifications, as well as a variety of uses in different applications will be readily apparent to those skilled in the art, and the general principles defined herein may be applied to a wide range of embodiments. Thus, the present disclosure is not intended to be limited to the example embodiments presented herein, and is to be accorded the widest scope consistent with the principles and novel features disclosed herein.

In the description provided, numerous specific details are set forth in order to provide a more thorough understanding of the present disclosure. However, it will be apparent to one skilled in the art that the present disclosure may be practiced without necessarily being limited to these specific details. In other instances, well-known structures and devices are shown in block diagram form, rather than in detail, in order to avoid obscuring the present disclosure.

All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described in the present disclosure with reference to the drawings. It should be noted that the drawings are only intended to facilitate the description of the features. They are not intended as an exhaustive description of the present disclosure or as a limitation on the scope of the present disclosure. In addition, an illustrated example need not have all the aspects or advantages shown. An aspect or an advantage described in conjunction with a particular example is not necessarily limited to that example and can be practiced in any other examples even if not so illustrated, or if not so explicitly described.

Furthermore, any element in a claim that does not explicitly state "means for" performing a specified function, or "step for" performing a specific function, is not to be interpreted as a "means" or "step" clause as specified in 35 U.S.C. §112(f). In particular, the use of "step of" or "act of" in the claims herein is not intended to invoke the provisions of 35 U.S.C. §112(f).

The labels "left," "right," "front," "back," "top," "bottom," "forward," "reverse," "clockwise" and "counter clockwise," if used, have been used for convenience purposes only and are not intended to imply any particular fixed direction. Instead, they are used to reflect relative locations and/or directions between various portions of an object.

## Claims

1. A semiconductor device (1) comprising:
a substrate (20); and
semiconductor assemblies (40, 40A-G) that are configured to be electrically connected together, each of the semiconductor assemblies (40, 40A-G) comprising:
a first semiconductor chip (41) that is at least partially between a first surface of the substrate (20) and a second surface of the substrate (20), the first surface facing in a first direction and the second surface facing in a second direction, opposite to the first direction; and
a voltage regulator (42) that is on the first surface of the substrate (20), overlaps with the first semiconductor chip (41) in the first direction, and is configured to be electrically connected to the first semiconductor chip (41),
the semiconductor device (1) further comprising a cooling plate on the second surface of the substrate (20),
wherein the cooling plate comprises liquid channels configured to exchange heat with the substrate (20), and
wherein the substrate (20) further comprises a liquid cooling channel (23) below the first semiconductor chip (41) in the second direction.

2. The semiconductor device (1) of claim 1, wherein the substrate (20) comprises a recess (22) and the first semiconductor chip (41) is at least partially in the recess (22).

3. The semiconductor device (1) of claim 1 or 2, wherein the substrate (20) is a wafer-scale substrate or a panel-scale substrate.

4. The semiconductor device (1) of any one of claims 1 to 3, further comprising at least one redistribution layer, RDL, above the first semiconductor chip (41) in the first direction,
wherein the at least one RDL is configured to electrically connect the first semiconductor chip (41) and the voltage regulator (42) of a same one of the semiconductor assemblies (40, 40A-G).

5. The semiconductor device (1) of any one of claims 1 to 4, wherein the substrate (20) further comprises a thermal via below the first semiconductor chip (41) in the second direction.

6. The semiconductor device (1) of any one of claims 1 to 5, wherein one of the semiconductor assemblies (40, 40A-G) further comprises an interposer (43) between the voltage regulator (42) and the first semiconductor chip (41) of the one of the semiconductor assemblies (40, 40A-G),
wherein the interposer (43) is configured to electrically connect the voltage regulator (42) and the first semiconductor chip (41) of the one of the semiconductor assemblies (40, 40A-G).

7. The semiconductor device (1) of claim 6, wherein the one of the semiconductor assemblies (40, 40A-G) further comprises a second semiconductor chip (45) between the interposer (43) and the first semiconductor chip (41) of the one of the semiconductor assemblies (40, 40A-G),
wherein the second semiconductor chip (45) is configured to be electrically connected to the voltage regulator (42) of the one of the semiconductor assemblies (40, 40A-G).

8. The semiconductor device (1) of any one of claims 1 to 7, wherein the first semiconductor chip (41) of at least one of the semiconductor assemblies (40, 40A-G) is an application-specific integrated circuit, ASIC, chip, a memory chip, a field programmable gate array, FPGA, a processor, or a coprocessor.

9. The semiconductor device (1) of any one of claims 1 to 8, wherein the substrate (20) comprises a glass substrate or a silicon substrate.

10. The semiconductor device (1) of any one of claims 1 to 9, wherein a smallest dimension of the substrate (20), in a plan view of the semiconductor device (1), is equal to or greater than 200 mm.

11. The semiconductor device (1) of any one of claims 1 to 10, wherein a diameter of the substrate (20), in a plan view of the semiconductor device (1), is equal to or greater than 210 mm.

## Patentansprüche

1. Halbleiterbauelement (1), aufweisend:
ein Substrat (20); und
Halbleiterbaugruppen (40, 40A-G), die so konfiguriert sind, dass sie elektrisch miteinander verbunden sind, wobei jede der Halbleiterbaugruppen (40, 40A-G) aufweist:
einen ersten Halbleiterchip (41), der sich zumindest teilweise zwischen einer ersten Oberfläche des Substrats (20) und einer zweiten Oberfläche des Substrats (20) befindet, wobei die erste Oberfläche in eine erste Richtung und die zweite Oberfläche in eine zweite Richtung, entgegengesetzt zur ersten Richtung, weist; und
einen Spannungsregler (42), der sich auf der ersten Oberfläche des Substrats (20) befindet, den ersten Halbleiterchip (41) in der ersten Richtung überlappt und so konfiguriert ist, dass er elektrisch mit dem ersten Halbleiterchip (41) verbunden ist,
wobei das Halbleiterbauelement (1) ferner eine Kühlplatte auf der zweiten Oberfläche des Substrats (20) aufweist,
wobei die Kühlplatte Flüssigkeitskanäle aufweist, die so konfiguriert sind, dass sie mit dem Substrat (20) Wärme austauschen, und
wobei das Substrat (20) ferner einen Flüssigkeitskühlkanal (23) unterhalb des ersten Halbleiterchips (41) in der zweiten Richtung aufweist.

2. Halbleiterbauelement (1) nach Anspruch 1, wobei das Substrat (20) eine Aussparung (22) aufweist und sich der erste Halbleiterchip (41) zumindest teilweise in der Aussparung (22) befindet.

3. Halbleiterbauelement (1) nach Anspruch 1 oder 2, wobei das Substrat (20) ein Substrat im Wafer-Maßstab oder ein Substrat im Panel-Maßstab ist.

4. Halbleiterbauelement (1) nach einem der Ansprüche 1 bis 3, das ferner zumindest eine Umverteilungsschicht (RDL) oberhalb des ersten Halbleiterchips (41) in der ersten Richtung aufweist,
wobei die zumindest eine RDL so konfiguriert ist, dass sie den ersten Halbleiterchip (41) und den Spannungsregler (42) von derselben der Halbleiterbaugruppen (40, 40A-G) elektrisch verbindet.

5. Halbleiterbauelement (1) nach einem der Ansprüche 1 bis 4, wobei das Substrat (20) ferner eine thermische Durchkontaktierung unterhalb des ersten Halbleiterchips (41) in der zweiten Richtung aufweist.

6. Halbleiterbauelement (1) nach einem der Ansprüche 1 bis 5, wobei eine der Halbleiterbaugruppen (40, 40A-G) ferner einen Interposer (43) zwischen dem Spannungsregler (42) und dem ersten Halbleiterchip (41) von der einen der Halbleiterbaugruppen (40, 40A-G) aufweist,
wobei der Interposer (43) so konfiguriert ist, dass er den Spannungsregler (42) und den ersten Halbleiterchip (41) von der einen der Halbleiterbaugruppen (40, 40A-G) elektrisch verbindet.

7. Halbleiterbauelement (1) nach Anspruch 6, wobei die eine der Halbleiterbaugruppen (40, 40A-G) ferner einen zweiten Halbleiterchip (45) zwischen dem Interposer (43) und dem ersten Halbleiterchip (41) von der einen der Halbleiterbaugruppen (40, 40A-G) aufweist,
wobei der zweite Halbleiterchip (45) so konfiguriert ist, dass er mit dem Spannungsregler (42) von der einen der Halbleiterbaugruppen (40, 40A-G) elektrisch verbunden ist.

8. Halbleiterbauelement (1) nach einem der Ansprüche 1 bis 7, wobei der erste Halbleiterchip (41) von zumindest einer der Halbleiterbaugruppen (40, 40A-G) eine anwendungsspezifische integrierte Schaltung (ASIC), ein Speicherchip, ein feldprogrammierbares Gate-Array (FPGA), ein Prozessor oder ein Coprozessor ist.

9. Halbleiterbauelement (1) nach einem der Ansprüche 1 bis 8, wobei das Substrat (20) ein Glassubstrat oder ein Siliziumsubstrat aufweist.

10. Halbleiterbauelement (1) nach einem der Ansprüche 1 bis 9, wobei eine kleinste Abmessung des Substrats (20) in einer Draufsicht auf das Halbleiterbauelement (1) größer oder gleich 200 mm ist.

11. Halbleiterbauelement (1) nach einem der Ansprüche 1 bis 10, wobei ein Durchmesser des Substrats (20) in einer Draufsicht auf das Halbleiterbauelement (1) größer oder gleich 210 mm beträgt.

## Revendications

1. Dispositif semi-conducteur (1) comprenant :
un substrat (20) ; et
des ensembles semi-conducteurs (40, 40A-G) qui sont configurés pour être électriquement connectés les uns aux autres, chacun des ensembles semi-conducteurs (40, 40A-G) comprenant :
une première puce semi-conductrice (41) qui est située au moins partiellement entre une première surface du substrat (20) et une deuxième surface du substrat (20), la première surface faisant face dans une première direction et la deuxième surface faisant face dans une deuxième direction, opposée à la première direction ; et
un régulateur de tension (42) qui est sur la première surface du substrat (20), chevauche la première puce semi-conductrice (41) dans la première direction, et est configuré pour être électriquement connecté à la première puce semi-conductrice (41),
le dispositif semi-conducteur (1) comprenant en outre une plaque de refroidissement sur la deuxième surface du substrat (20),
dans lequel la plaque de refroidissement comprend des canaux de liquide configurés pour échanger de la chaleur avec le substrat (20), et
dans lequel le substrat (20) comprend en outre un canal de refroidissement par liquide au-dessous de la première puce semi-conductrice (41) dans la deuxième direction.

2. Dispositif semi-conducteur (1) selon la revendication 1, dans lequel le substrat (20) comprend un évidement (22) et la première puce semi-conductrice (41) est au moins partiellement dans l'évidement (22).

3. Dispositif semi-conducteur (1) selon la revendication 1 ou 2, dans lequel le substrat (20) est un substrat à l'échelle d'une plaquette ou un substrat à l'échelle d'un panneau.

4. Dispositif semi-conducteur (1) selon l'une quelconque des revendications 1 à 3, comprenant en outre au moins une couche de redistribution, RDL, au-dessus de la première puce semi-conductrice (41) dans la première direction,
dans lequel ladite au moins une RDL est configurée pour connecter électriquement la première puce semi-conductrice (41) et le régulateur de tension (42) d'un même ensemble semi-conducteur parmi les ensembles semi-conducteurs (40, 40A-G).

5. Dispositif semi-conducteur (1) selon l'une quelconque des revendications 1 à 4, dans lequel le substrat (20) comprend en outre un via thermique au-dessous de la première puce semi-conductrice (41) dans la deuxième direction.

6. Dispositif semi-conducteur (1) selon l'une quelconque des revendications 1 à 5, dans lequel l'un des ensembles semi-conducteurs (40, 40A-G) comprend en outre un interposeur (43) entre le régulateur de tension (42) et la première puce semi-conductrice (41) dudit ensemble semi-conducteur (40, 40A-G),
dans lequel l'interposeur (43) est configuré pour connecter électriquement le régulateur de tension (42) et la première puce semi-conductrice (41) dudit ensemble semi-conducteur (40, 40A-G).

7. Dispositif semi-conducteur (1) selon la revendication 6, dans lequel ledit ensemble semi-conducteur (40, 40A-G) comprend en outre une deuxième puce semi-conductrice (45) entre l'interposeur (43) et la première puce semi-conductrice (41) dudit ensemble semi-conducteur (40, 40A-G),
dans lequel la deuxième puce semi-conductrice (45) est configurée pour être électriquement connectée au régulateur de tension (42) dudit ensemble semi-conducteur (40, 40A-G).

8. Dispositif semi-conducteur (1) selon l'une quelconque des revendications 1 à 7, dans lequel la première puce semi-conductrice (41) d'au moins l'un des ensembles semi-conducteurs (40, 40A-G) est une puce de circuit intégré spécifique à une application, ASIC, une puce mémoire, un réseau de portes programmable in situ, FPGA, un processeur ou un coprocesseur.

9. Dispositif semi-conducteur (1) selon l'une quelconque des revendications 1 à 8, dans lequel le substrat (20) comprend un substrat en verre ou un substrat en silicium.

10. Dispositif semi-conducteur (1) selon l'une quelconque des revendications 1 à 9, dans lequel une plus petite dimension du substrat (20), dans une vue en plan du dispositif semi-conducteur (1), est supérieure ou égale à 200 mm.

11. Dispositif semi-conducteur (1) selon l'une quelconque des revendications 1 à 10, dans lequel un diamètre du substrat (20), dans une vue en plan du dispositif semi-conducteur (1), est supérieur ou égal à 210 mm.
